(19) Europäisches Patentamt
European Patent Office
Office européen des brevets

(11) EP 3 112 178 B1

(12) # EUROPEAN PATENT SPECIFICATION

(45) Date of publication and mention of the grant of the patent:
**16.05.2018 Bulletin 2018/20**

(21) Application number: **15755390.0**

(22) Date of filing: **16.02.2015**

(51) Int Cl.:
***B41N 1/14*** (2006.01) ***B41C 1/10*** (2006.01)
***G03F 7/00*** (2006.01) ***G03F 7/004*** (2006.01)
***G03F 7/027*** (2006.01) ***G03F 7/38*** (2006.01)

(86) International application number:
**PCT/JP2015/054145**

(87) International publication number:
**WO 2015/129504 (03.09.2015 Gazette 2015/35)**

(54) **ON-MACHINE DEVELOPMENT TYPE LITHOGRAPHIC PRINTING PLATE PRECURSOR PROCESSING METHOD AND PRINTING METHOD**

VERFAHREN ZUR VERARBEITUNG EINES LITHOGRAFIEDRUCKPLATTENVORLÄUFERS MIT ENTWICKLUNG AUF EINER MASCHINE UND DRUCKVERFAHREN

PROCÉDÉ DE TRAITEMENT DE PRÉCURSEUR DE PLAQUE D'IMPRESSION LITHOGRAPHIQUE DU TYPE DÉVELOPPEMENT SUR MACHINE, ET PROCÉDÉ D'IMPRESSION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.02.2014 JP 2014035791**

(43) Date of publication of application:
**04.01.2017 Bulletin 2017/01**

(73) Proprietor: **Fujifilm Corporation**
**Minato-ku**
**Tokyo 106-8620 (JP)**

(72) Inventor: **WARIISHI, Koji**
**Haibara-gun**
**Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**EP-A2- 0 113 521** **EP-A2- 1 256 461**
**JP-A- 2011 177 983** **JP-A- 2011 177 983**
**JP-A- 2013 184 116** **JP-A- 2013 194 695**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 112 178 B1

Printed by Jouve, 75001 PARIS (FR)

## Description

## BACKGROUND OF THE INVENTION

1. Field of the Invention

The present invention relates to a method for processing an on-press development-type lithographic printing plate precursor and a printing method. Moreover, the present invention relates to a method for processing an on-press development-type lithographic printing plate precursor and a printing method in which edge stains are prevented. A lithographic printing plate having a wide water width during printing is provided by the method of the present invention.

2. Description of the Related Art

Currently, when producing a lithographic printing plate, image exposure is performed using computer-to-plate (CTP) technology. That is, the lithographic printing plate precursor is directly subjected to scanning exposure without interposing a lithographic film, using a laser or a laser diode. Accordingly, problems relating to the lithographic printing plate precursor have been changed to improvements in image forming characteristics, printing characteristics, physical characteristics, and the like which correspond to the CTP technology.

Furthermore, an environmental problem relating to a waste liquid in accordance with wet processing such as development processing has been closed up as another problem relating to the lithographic printing plate precursor from the viewpoint of growing interest in the global environment. Accordingly, simplification of development processing or non-processing is oriented. A method called "on-press development" is proposed as a simple development process. That is, the method is a method in which removal of an unnecessary portion of an image recording layer is performed in an initial stage of a usual printing step while mounting a lithographic printing plate precursor, which has been exposed to light, on a printing press as it is without performing development processing in the related art.

In addition, in a case of performing printing using a lithographic printing plate, an end portion of the printing plate is at a position outside the paper surface when performing printing on paper having a size smaller than that of the printing plate using a typical sheet-fed printing machine, and therefore, the end portion does not affect the quality of printing. However, when continuously performing printing, such as newspaper printing, on roll-shaped paper using a rotary press, the end portion of the printing plate is within the surface of the rolled paper. Therefore, ink attached to the end portion generates linear stains (edge stains) after being transferred on the paper, thereby significantly impairing the commercial value of a printed matter.

As a method for preventing the edge stains in the on-press development-type lithographic printing plate precursor, subjecting a region within 1 cm from an end portion of an on-press development-type lithographic printing plate precursor for newspaper printing to a process using a liquid containing an organic solvent and a hydrophilic resin has been proposed (refer to JP2011-177983A).

## SUMMARY OF THE INVENTION

However, although the edge stains are improved to some extent according to the above-described prior art, it has been found that, in some cases, stains in an unexposed portion mainly in a region (hereinafter, also referred to as a region in the vicinity of an edge portion) near a boundary between a portion which is coated with a processing liquid and a portion which is not coated with a processing liquid are increased. In addition, it has been found that, in a case where the amount of dampening water is made to be small during printing, the edge stains are not sufficiently eliminated. This means that the water width during printing is narrow. The water width refers to a width of the amount of dampening water, which is required for maintaining printability, from an upper limit to a lower limit, and a wide water width is strongly required for performing stable printing.

An object of the present invention is to provide a method for processing an on-press development-type lithographic printing plate precursor and a printing method which do not cause edge stains and in which there are no stains in an unexposed portion in a region in the vicinity of an edge portion. The method of the present invention will also result in a lithographic printing plate having a wide water width during printing with respect to the edge stains.

An object of the present invention is achieved through the following methods.

(1) A method for processing an on-press development-type lithographic printing plate precursor as defined in claim 1.
(2) A printing method as defined in claim 8.

According to the present invention, it is possible to provide a method for processing an on-press development-type lithographic printing plate precursor and a printing method which do not cause edge stains and in which there are

no stains in an unexposed portion in a region in the vicinity of and edge portion. The method of the present invention will also result in a lithographic printing plate having a wide water width during printing with respect to the edge stains .

## BRIEF DESCRIPTION OF THE DRAWINGS

Fig. 1 is a view schematically showing a sectional shape of a lithographic printing plate precursor.
Fig. 2 is a sectional view showing a cutting unit of a slitter device.

## DESCRIPTION OF THE PREFERRED EMBODIMENTS

Hereinafter, the present invention will be described in detail.

A method for processing an on-press development-type lithographic printing plate precursor according to the present invention is a processing method in which a region within 1 cm from an end portion on a plate surface of the lithographic printing plate precursor is coated with a processing liquid containing a hydrophilizing agent after subjecting the on-press development-type lithographic printing plate precursor having an image recording layer on a support to image exposure, before mounting the on-press development-type lithographic printing plate precursor on a printing press, and is a processing method in which the coating is performed such that coating means does not come into contact with the plate surface. In the processing method of the present invention, when coating the region of the end portion of the plate surface of the lithographic printing plate precursor with a processing liquid containing a hydrophilizing agent, the coating is performed such that coating means does not come into contact with the plate surface. It is considered that, when the coating means comes into contact with the plate surface, a film of the image recording layer is removed since the image recording layer is damaged by physical force applied to the image recording layer of the lithographic printing plate precursor, and components of this removed film become residues and are attached to the plate surface, thereby causing staining in a non-image portion. However, such a problem is not caused in the processing method of the present invention. Furthermore, it has been found that an excellent effect which is totally unexpected is recognized, for example, generation of edge stains is suppressed even in a case where the amount of dampening water during printing is made to be small, by performing the coating such that the coating means does not come into contact with the plate surface, compared to a case where the coating means is brought into contact with the plate surface.

First, the processing liquid containing a hydrophilizing agent which is used for the processing method according to the present invention will be described.

[Processing Liquid Containing Hydrophilizing agent]

The processing liquid containing a hydrophilizing agent which is used for the processing method of the present invention may be an aqueous solution or may be a processing liquid (emulsion-type processing liquid) which is obtained by emulsifying an oil phase component and a water phase compound, but is preferably an aqueous solution.

(Hydrophilizing agent)

The hydrophilizing agent contained in the processing liquid is preferably at least one selected from a phosphoric acid compound, a phosphonic acid compound, an anionic surfactant and a nonionic surfactant. As the hydrophilizing agent, phosphoric acid compound and phosphonic acid compound are preferable.

The hydrophilizing agent is more preferably at least one selected from a phosphoric acid compound and a phosphonic acid compound, and at least one selected from an anionic surfactant and a nonionic surfactant.

<Phosphoric Acid Compound>

As the phosphoric acid compound used as a hydrophilizing agent, a phosphoric acid and a salt thereof are preferably used, and examples thereof include a phosphoric acid, a metaphosphoric acid, ammonium primary phosphate, ammonium secondary phosphate, sodium primary phosphate, sodium secondary phosphate, sodium tertiary phosphate, potassium primary phosphate, potassium secondary phosphate, sodium tripolyphosphate, potassium pyrophosphate, and sodium hexametaphosphate. In addition, a combination of an acid and a salt, for example, phosphoric acid/ammonium phosphoric acid, phosphoric acid/sodium phosphoric acid, metaphosphoric acid/ammonium phosphoric acid can be preferably used.

<Phosphonic Acid Compound>

As the phosphonic acid compound used as a hydrophilizing agent, a phosphonic acid, a salt thereof, and an ester thereof are preferably used, and examples thereof include an ethylphosphonic acid, a propylphosphonic acid, an isopropylphosphonic acid, a butylphosphonic acid, a hexylphosphonic acid, an octylphosphonic acid, a dodecylphosphonic acid, an octadecylphosphonic acid, a 2-hydroxyethylphosphonic acid, and sodium salts or potassium salts thereof; a polyvinyl phosphonic acid; alkylphosphonic acid monoalkyl esters such as methyl methylphosphonate, methyl ethylphosphonate, and methyl 2-hydroxyethyl phosphonate, and sodium salts or potassium salts thereof; alkylene diphosphonic acids such as a methylene diphosphonic acid, an ethylene diphosphonic acid, and sodium salts or potassium salts thereof.

The content of the phosphoric acid compound or the phosphonic acid compound in the processing liquid used in the present invention is preferably 0.5 mass% to 10.0 mass% and more preferably 0.5 mass% to 5 mass% based on the total mass of the processing liquid. In this range, the processing liquid is more excellent in terms of controlling edge stains and controlling crystal precipitation after coating.

<Anionic Surfactant>

Examples of the anionic surfactant used as a hydrophilizing agent include fatty acid salts, abietic acid salts, hydroxy alkane sulfonic acid salts, alkane sulfonic acid salts, dialkyl sulfosuccinate salts, benzene sulfonic acid salts, linear alkyl benzene sulfonic acid salts, branched alkyl benzene sulfonic acid salts, naphthalene sulfonic acid salts, alkyl naphthalene sulfonic acid salts, alkyl phenoxy polyoxyethylene propyl sulfonic acid salts, polyoxyethylene aryl ether sulfuric acid ester salts, polyoxyethylene alkyl sulfophenyl ether salts, N-methyl-N-oleyl taurine sodiums, N-alkyl sulfosuccinic acid monoamide disodium salts, petroleum sulfonic acid salts, sulfated castor oil, sulfated beef tallow oil, sulfate ester salts of a fatty acid alkyl ester, alkyl sulfate ester salts, polyoxyethylene alkyl ether sulfuric ester salts, fatty acid monoglyceride sulfuric acid ester salts, polyoxyethylene alkylphenyl ether sulfuric acid ester salts, polyoxyethylene styryl phenyl ether sulfuric acid ester salts, alkyl phosphoric acid ester salts, polyoxyethylene alkyl ether phosphoric acid ester salts, polyoxyethylene alkyl phenyl ether phosphoric acid ester salts, partially saponified products of a styrene-maleic anhydride copolymer, partially saponified products of an olefin-maleic anhydride copolymer, and naphthalene sulfonate formalin condensates. An anionic surfactant based on fluorine or silicon does not correspond to the anionic surfactant used as a hydrophilizing agent in the present invention.

In the anionic surfactants, dialkyl sulfosuccinate salts, alkyl sulfate ester salts, polyoxyethylene aryl ether sulfuric acid ester salts, and alkyl naphthalene sulfonic acid salts are preferably used.

Specifically, preferred examples thereof include an anionic surfactant represented by the following General Formula (I-A) or General Formula (I-B).

$$(R^1)_p—Ar^1—(SO_3^{\ominus})_q \ M_1^{\oplus} \qquad (I-A)$$

$$(R^2)_m—Ar^2—Y\text{-}O(R^3O)_n\text{-}SO_3^{\ominus} \ M_2^{\oplus} \qquad (I-B)$$

In General Formula (I-A), $R^1$ represents a liner or branched alkyl group having 1 to 20 carbon atoms; p represents 0, 1, or 2; $Ar^1$ represents an aryl group having 6 to 10 carbon atoms; q represents 1, 2, or 3; and $M_1^+$ represents $Na^+$, $K^+$, $Li^+$, or $NH_4^+$. In a case where p is 2, $R^1$s existing in plural numbers may be the same as or different from each other.

In General Formula (I-B), $R^2$ represents a linear or branched alkyl group having 1 to 20 carbon atoms; m represents 0, 1, or 2; $Ar^2$ represents an aryl group having 6 to 10 carbon atoms; Y represents a single bond or an alkylene group having 1 to 10 carbon atoms; $R^3$ represents a linear or branched alkylene group having 1 to 5 carbon atoms; n represents an integer of 1 to 100; and $M_2^+$ represents $Na^+$, $K^+$, $Li^+$, or $NH_4^+$. In a case where m is 2, $R^2$s existing in plural numbers may be the same as or different from each other; and in a case where n is greater than or equal to 2, $R^3$s existing in plural numbers may be the same as or different from each other.

In General Formula (I-A) and General Formula (I-B), preferred examples of $R_1$ and $R_2$ include $CH_3$, $C_2H_5$, $C_3H_7$, or $C_4H_9$. Preferred examples of $R_3$ include $-CH_2-$, $-CH_2CH_2-$, or $-CH_2CH_2CH_2-$, and $-CH_2CH(CH_3)-$, and more preferred examples thereof include $-CH_2CH_2-$. p and m are preferably 0 or 1 and p is particularly preferably 0. Y is preferably a single bond. n is preferably an integer of 1 to 20.

Specific examples of the anionic surfactant represented by compounds represented by General Formula (I-A) or General Formula (I-B) are shown below.

(1) 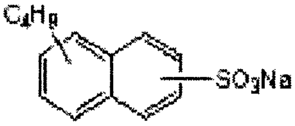

(2) 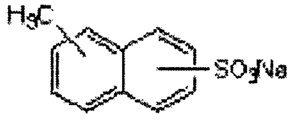

(3) 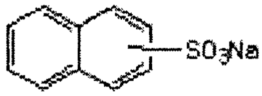

(4) 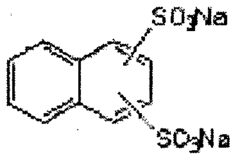

(5) 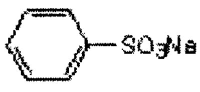

(6) 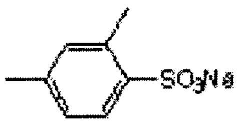

(7) 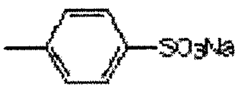

(8) 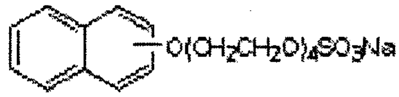

(9) 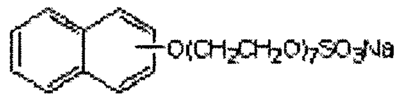

(10) 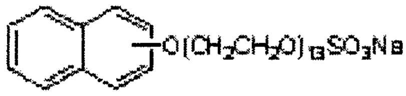

(11) 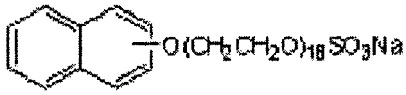

(12) 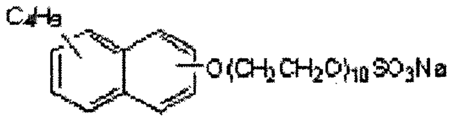

(13) 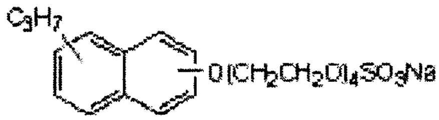

(14) 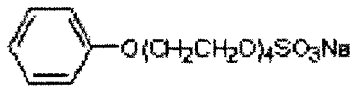

(15) 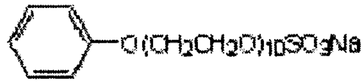

(16) 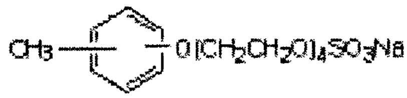

(17) 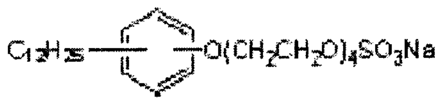

<Nonionic Surfactant>

Examples of the nonionic surfactant used as a hydrophilizing agent include polyoxyethylene alkyl ethers, polyoxyethylene aryl ethers, polyoxyethylene alkyl esters, glycerin fatty acid partial esters, sorbitan fatty acid partial esters, pentaerythritol fatty acid partial esters, propylene glycol mono fatty acid esters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylene glycerin fatty acid partial esters, fatty acid diethanolamides, N,N-bis-2-hydroxyalkylamines, polyoxyethylene alkylamines, triethanolamine fatty acid esters, trialkylamine oxides, and polyoxyethylene-polyoxypropylene block copolymers. A nonionic surfactant based on fluorine or silicon does not correspond to the nonionic surfactant used as a hydrophilizing agent in the present invention.

In the nonionic surfactants, polyoxyethylene aryl ethers, polyoxyethylene-polyoxypropylene block copolymers, and the like are preferably used.

Specifically, preferred examples thereof include a nonionic surfactant represented by the following General Formula (II-A).

$$(R^4)_s\text{-}Ar^3\text{-}O(CH_2CH_2O)_t(CH_2CH(CH_3)O)_uH \qquad \text{(II-A)}$$

In General Formula (II-A), $R^4$ represents a hydrogen atom or an alkyl group having 1 to 20 carbon atoms; s represents 0, 1, or 2; $Ar^3$ represents an aryl group having 6 to 10 carbon atoms; and t and u each represent an integer of 0 to 100, but there is no case where both t and u are 0. In a case where s is 2, $R^4$s existing in plural numbers may be the same as or different from each other.

Examples of the compound represented by General Formula (II-A) include polyoxyethylene phenyl ether, polyoxyethylene methyl phenyl ether, polyoxyethylene octyl phenyl ether, polyoxyethylene nonyl phenyl ether, polyoxyethylene naphthyl ether, polyoxyethylene methyl naphthyl ether, polyoxyethylene octyl naphthyl ether, and polyoxyethylene nonyl naphthyl ether.

In the compound represented by General Formula (II-A), the number (t) of repeating units of polyoxyethylene chains is preferably 2 to 50 and more preferably 4 to 30. The number (u) of repeating units of polyoxypropylene chains is preferably 0 to 10 and more preferably 0 to 5. The polyoxyethylene moiety and the polyoxypropylene moiety may be present at random or in blocks.

A specific example of the nonionic surfactant will be shown. The oxyethylene repeating unit and the oxypropylene repeating unit in the following exemplified compound "Y-5" can take any aspects of the random bond and the block link.

Y-1

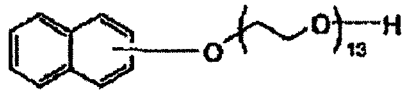

Y-2

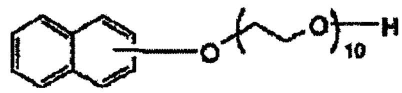

Y-3

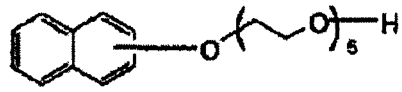

Y-4

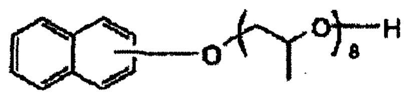

Y-5

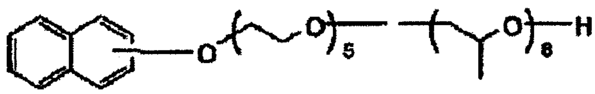

Y-6

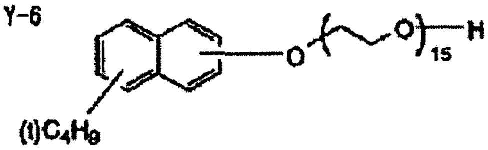

Y-7

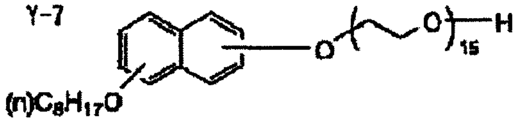

Y-8

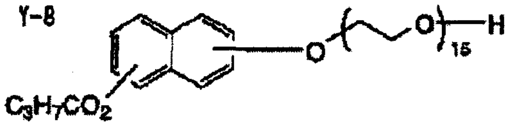

Y-9

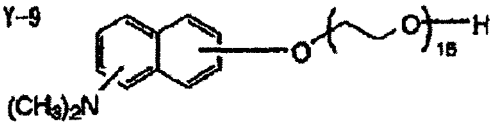

Y-10

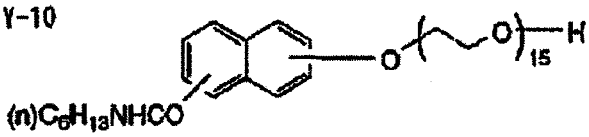

Y-11

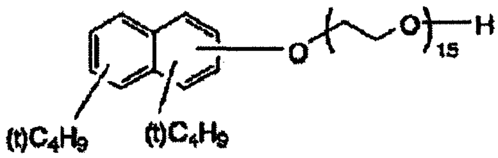

Y-12

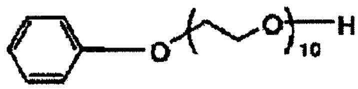

Y-13

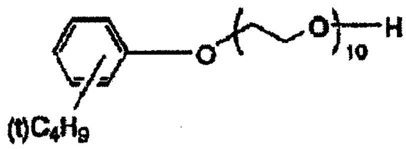

Y-14

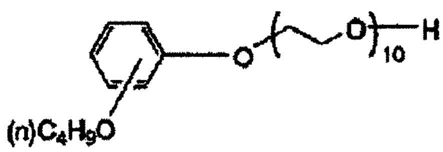

Y-15

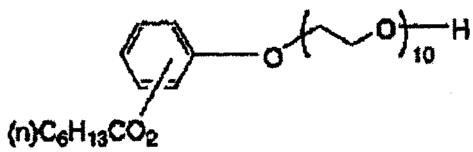

Y-16

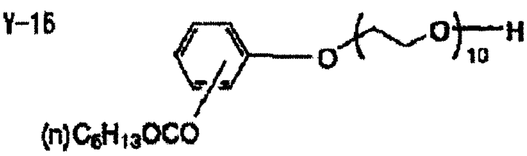

Two or more types of the above-described surfactants can also be used in combination. Examples thereof include combined use of two or more types of anionic surfactants, different from each other, combined use of two or more types of nonionic surfactants, and combined use of an anionic surfactant and a nonionic surfactant.

The content of an anionic surfactant or a nonionic surfactant in the processing liquid used in the present invention is preferably 0.01 mass% to 20 mass% and more preferably 0.1 mass% to 15 mass% based on the total mass of the processing liquid.

According to the method for processing a lithographic printing plate precursor according to the present invention, it is possible to achieve a desired effect method which do not cause edge stains and in which there are no stains in an unexposed portion in a region in the vicinity of and edge portion and a lithographic printing plate having a wide water width during printing with respect to the edge stains is provided, using the above-described processing liquid containing a hydrophilizing agent. However, the processing liquid may further contain a water-soluble resin, an organic solvent, a

plasticizer, and other additives as necessary.

<Water-Soluble Resin>

A water-soluble resin can be contained for the purpose of persistence of the effect of preventing edge stains caused by adjustment of viscosity and formation of a hydrophilic protection film. Examples of the water-soluble resin include water-soluble resins which are classified as polysaccharides, polyvinyl alcohol, polyvinyl pyrrolidone, polyacrylamide, and copolymers thereof, a vinyl methyl ether/maleic anhydride copolymer, a vinyl acetate/maleic anhydride copolymer, and a styrene/maleic anhydride copolymer.
As the polysaccharide, starch derivatives (for example, dextrin, enzymatic degradation dextrin, a hydroxypropylated starch, a carboxymethylated starch, a phosphoric acid-esterified starch, a polyoxyalkylene grafted starch, and a cyclodextrin), celluloses (for example, carboxymethyl cellulose, carboxyethyl cellulose, methyl cellulose, hydroxypropyl cellulose, and methylpropyl cellulose), carrageenan, an alginic acid, guar gum, Locust bean gum, xanthan gum, gum arabic, and soybean polysaccharides.
In the water-soluble resins, starch derivatives such as dextrin and polyoxyalkylene grafted starch, gum arabic, carboxymethyl cellulose, and soybean polysaccharides are preferably used.
Two or more types of these water-soluble resins may be used in combination. The content of the water-soluble resins is preferably 0.5 mass% to 30 mass% and more preferably 1 mass% to 10 mass% based on the total mass of the processing liquid. In this range, it is possible to obtain favorable coating properties of the processing liquid and persistence of the effect of preventing edge stains caused by formation of a hydrophilic protection film.

<Organic Solvent>

An organic solvent can be contained for the purpose of adjusting solubility of a hydrophilizing agent and a water-soluble resin and promoting swelling of an image recording layer. Examples of the organic solvent include an alcohol-based solvent, a ketone-based solvent, an ester-based solvent, an amide-based solvent, and a hydrocarbon-based solvent. In the organic solvents, an alcohol-based solvent and a hydrocarbon-based solvent are preferably used.
As the alcohol-based solvent, monohydric alcohol or polyhydric alcohol may be used. Examples of the monohydric alcohol include methyl alcohol, n-propyl alcohol, iso-propylalcohol, n-butyl alcohol, tert-butyl alcohol, n-amyl alcohol, diacetone alcohol, 1-methoxy-2-propanol, furfuryl alcohol, 2-octanol, 2-ethylhexanol, nonanol, n-decanol, undecanol, n-dodecanol, trimethylnonyl alcohol, benzyl alcohol, phenethyl alcohol, ethylene glycol monoisoamyl ether, ethylene glycol monophenyl ether, ethylene glycol monobenzyl ether, and ethylene glycol monohexyl ether.
Examples of the polyhydric alcohol include ethylene glycol, propylene glycol, triethylene glycol, butylene glycol, hexylene glycol, diethylene glycol, dipropylene glycol, and glycerin.
Benzyl alcohol, phenethyl alcohol, furfuryl alcohol, and glycerin are preferably used.
Examples of the hydrocarbon-based solvent include an aromatic or aliphatic compound (mineral spirit) of a petroleum distillate, and squalane.
Two or more types of the organic solvent may be used in combination. The amount of the organic solvent is preferably 0.5 mass% to 10 mass% and more preferably 1 mass% to 5 mass% based on the total mass of the processing liquid. In this range, the organic solvent is excellent in control of the coating width of the processing liquid and permeability to the image recording layer.

<Plasticizer>

Examples of the plasticizer include plasticizer having lower than or equal to 15°C of a solidifying point, for example, phthalic acid diesters, such as dibutyl phthalate, diheptyl phthalate, di-n-octyl phthalate, di(2-ethylhexyl)phthalate, dinonyl phthalate, didecyl phthalate, dilauryl phthalate, and butyl benzyl phthalate; aliphatic dibasic acid esters such as dioctyl adipate, butyl glycol adipate, dioctyl azelate, dibutyl sebacate, di(2-ethylhexyl)sebacate, and dioctyl sebacate; epoxidized triglycerides such as epoxidized soybean oil; phosphoric acid esters such as tricresyl phosphate, trioctyl phosphate, and tris chloroethyl phosphate; and benzoic acid esters such as benzyl benzoate.
Two or more types of the plasticizer may be used in combination. The amount of the plasticizer is preferably 0.5 mass% to 10 mass% and more preferably 1 mass% to 5 mass% based on the total mass of the processing liquid.

<Other additives>

The processing liquid containing a hydrophilizing agent may contain mineral salts such as nitrate and sulfate, a preservative, and an anti-foaming agent in addition to the above-described components.
Examples of the mineral salts include magnesium nitrate, sodium nitrate, potassium nitrate, ammonium nitrate,

sodium sulfate, potassium sulfate, ammonium sulfate, sodium hydrogen sulfate, and nickel sulfate.

Examples of the prevervative include phenol or derivatives thereof, formalin, imidazole derivatives, sodium dehydroacetate, 4-isothiazolin-3-one derivatives, benzisothiazolin-3-one, benzotriazole derivatives, amidine guanidine derivatives, quaternary ammonium salts, derivatives of pyridine, quinoline, and guanidine, diazine, triazole derivatives, oxazole, oxazine derivatives, nitro bromo alcohol-based 2-bromo-2-nitropropane-1,3-diol, 1,1-dibromo-1-nitro-2-ethanol, and 1,1-dibromo-1-nitro-2-propanol.

As the anti-foaming agent, general silicon-based self-emulsifying type and emulsifying type anti-foaming agents and nonionic surfactants with HLB of 5 or less may be used.

The processing liquid containing a hydrophilizing agent may contain a cationic surfactant or an amphoteric surfactant. Examples of the cationic surfactants include alkylamine salts, quaternary ammonium salts, polyoxyalkylamine salts, and polyethylene polyamine derivatives. Examples of the amphoteric surfactant include carboxy betaines, amino carboxylic acids, sulfobetaines, amino sulfuric acid esters, and imidazolines.

(Preparation of Processing Liquid Containing Hydrophilizing agent)

The processing liquid containing a hydrophilizing agent can be prepared in accordance with a usual method. In a case where the processing liquid is an aqueous solution, the processing liquid is prepared by dissolving a hydrophilizing agent and other components as necessary in water (distilled water, ion exchange water, desalted water, or the like).

The emulsion type processing liquid can also be prepared in accordance with a usual method. Emulsification and dispersion while preparing a processing liquid can be performed through a method for making an emulsion using a pressure-type homogenizer after dripping an oil phase which has been separately prepared and consists of an organic solvent into the water phase which contains a hydrophilizing agent and has been prepared at a temperature of 40°C ± 5°C while stirring the water phase, and sufficiently stirring the mixture.

In some cases, a processing liquid containing a hydrophilizing agent is first prepared in a form of being concentrated, and is appropriately diluted when in use.

[Processing Method]

The method for processing a lithographic printing plate precursor using the processing liquid containing a hydrophilizing agent will be described. According to the processing method according to the present invention, a region within 1 cm from an end portion on the plate surface of an image-exposed on-press development-type lithographic printing plate precursor is coated with the processing liquid containing a hydrophilizing agent such that coating means does not come into contact with the plate surface. The plate surface of the lithographic printing plate precursor means a plate surface of the lithographic printing plate precursor on a side having an image recording layer, and is, in general, the surface of the image recording layer or the surface of a protective layer provided on the image recording layer. The end portion indicates a portion of an edge which is formed through a step of cutting the lithographic printing plate precursor in a sheet shape in a process of manufacturing the lithographic printing plate precursor.

The coating of the processing liquid containing a hydrophilizing agent is performed in a region within 1 cm from an end portion. In general, there is no image in the region within 1 cm from an end portion. Coating using the processing liquid is preferably performed in a region within 0.5 cm from an end portion and is particularly preferably performed in a region within 0.3 cm from an end portion.

The coating amount of the processing liquid with which the region of the end portion is coated is preferably 0.05 g/$m^2$ to 3 g/$m^2$ and more preferably 0.1 g/$m^2$ to 2 g/$m^2$ as the solid content after drying. This range is preferable from the viewpoints of prevention of adhesion of lithographic printing plate precursors to each other due to sticky coated portions and an influence on on-press developability.

In the processing method according to the present invention, coating using the processing liquid containing a hydrophilizing agent is performed such that coating means does not come into contact with the plate surface. The coating performed using the processing liquid such that the coating means does not come into contact with the plate surface is coating performed such that the plate surface of a lithographic printing plate precursor is not damaged by physical force applied to the plate surface by being brought into contact with the coating means. The coating means which can be used includes various types of non-contact type coating means. As an example of the non-contact type coating means, a quantitative liquid discharge device is preferably used. The quantitative liquid discharge device is a device which can quantitatively supply a liquid with high accuracy, and examples thereof include coating means in a spray system, an inkjet system, a dispenser system, a die coating system, and the like. Among these, coating means in a dispenser system is preferable.

In contrast, in coating using cloth, a molton roll, or the like in which a processing liquid is contained, coating means comes into contact with the plate surface of the lithographic printing plate precursor as described in JP2011-177983A. Therefore, the coating using cloth, a molton roll, or the like does not correspond to the coating using

the processing liquid according to the present invention which is performed such that the coating means does not come into contact with the plate surface.

As the inkjet system, it is possible to use an electrification control system, a pressurized vibration system, an electromechanical conversion system, an electrothermal conversion system, and an electrostatic suction system.

As the dispenser system, it is possible to use an air compression system, a valve opening/closing system, a piston system, a tube system, and a screw discharge system.

As an aspect of coating a lithographic printing plate precursor after image exposure with a processing liquid, a region of an end portion of a sheet-shaped lithographic printing plate precursor may be coated with a processing liquid one by one, or a region of end portions of lithographic printing plate precursors which are stacked on a stocker of a setter in a bundled state may be coated with a processing liquid after exposure. The aspect of coating the lithographic printing plate precursor one by one is preferable from the viewpoint of preventing adhesion of lithographic printing plate precursors to each other due to sticky coated portions.

In a case where a processing liquid contains a plurality of components, for example, in a case where the processing liquid contains the surfactant and other components, a method for performing coating using a processing liquid containing a surfactant and other components all at once is preferable, but a sequential coating method in which a solution containing a surfactant is used for coating, and then, a solution containing other components are used for coating can also be used. Each of the solutions can also be used for coating plural times. In addition, a drying step may be performed after each of the coating steps.

In addition, an image recording layer of a region of an end portion may be removed by applying a high output carbon dioxide gas laser or performing cutting, before coating the lithographic printing plate precursor after image exposure with a processing liquid.

The drying step can be performed using an oven or can be performed by blowing dry air. In addition, these methods may be used in combination. The drying temperature is preferably 50°C to 250°C and more preferably 60°C to 160°C. The drying time is preferably 3 seconds to 180 seconds and more preferably 5 seconds to 90 seconds. The drying step is performed by appropriately combining the drying temperature and the drying time within a range in which there is no adverse influence on the performance of the lithographic printing plate precursor.

Next, the on-press development-type lithographic printing plate precursor used for the processing method according to the present invention will be described.

[On-Press Development-Type Lithographic Printing Plate Precursor]

The on-press development-type lithographic printing plate precursor (hereinafter, in some cases, also simply referred to as a lithographic printing plate precursor) used for the processing method of the present invention has an image recording layer on a support. The lithographic printing plate precursor may have an undercoat layer (in some cases, also referred to as an interlayer) between the support and the image recording layer and a protective layer (in some cases, also referred to as an overcoat layer) on the image recording layer as necessary.

[Image Recording Layer]

The image recording layer of the lithographic printing plate precursor is an image recording layer of which a non-image portion is removed by at least one of neutral to alkaline dampening water or printing ink on a printing press.

According to one aspect of the present invention, the image recording layer is an image recording layer (hereinafter, also referred to as an image recording layer A) containing an infrared absorber, a polymerization initiator, a polymerizable compound, and a binder polymer.

According to another aspect of the present invention, the image recording layer is an image recording layer (hereinafter, also referred to as an image recording layer B) containing an infrared absorber, a polymerization initiator, a polymerizable compound, and a particulate shape polymer compound.

According to still another aspect of the present invention, the image recording layer is an image recording layer (hereinafter, also referred to as an image recording layer C) containing an infrared absorber and a thermoplastic fine particle polymer.

(Image Recording Layer A)

The image recording layer A contains an infrared absorber, a polymerization initiator, a polymerizable compound, and a binder polymer. Hereinafter, the constituent components of the image recording layer A will be described.

<Infrared Absorber>

The infrared absorber has a function of converting absorbed infrared rays into heat and a function of causing electron transfer and/or energy transfer to a polymerization initiator to be described below after being excited by the infrared rays. The infrared absorber used in the present invention is preferably a dye or a pigment having a maximum absorption at a wavelength of 760 nm to 1,200 nm and more preferably a dye having a maximum absorption at a wavelength of 760 nm to 1,200 nm.

As the dye, it is possible to use a commercially available dye and a well-known dye disclosed in literature, for example, "Dye Handbook" (edited by The Society of Synthetic Organic Chemistry, Japan, published in 1970 (S45)) can be used. Specific examples thereof include dyes such as azo dyes, metal complex salt azo dyes, pyrazolone azo dyes, naphthoquinone dyes, anthraquinone dyes, phthalocyanine dyes, carbonium dyes, quinone imine dyes, methine dyes, cyanine dyes, squarylium coloring matters, pyrylium salts, and metal thiolate complexes.

Particularly preferred examples of these dyes include cyanine coloring matters, squarylium coloring matters, pyrylium salts, nickel thiolate complexes, and indolenine cyanine coloring matters. Furthermore, cyanine coloring matters or indolenine cyanine coloring matters are preferable, and particularly preferred examples thereof include cyanine coloring matters represented by the following General Formula (a).

General Formula (a)

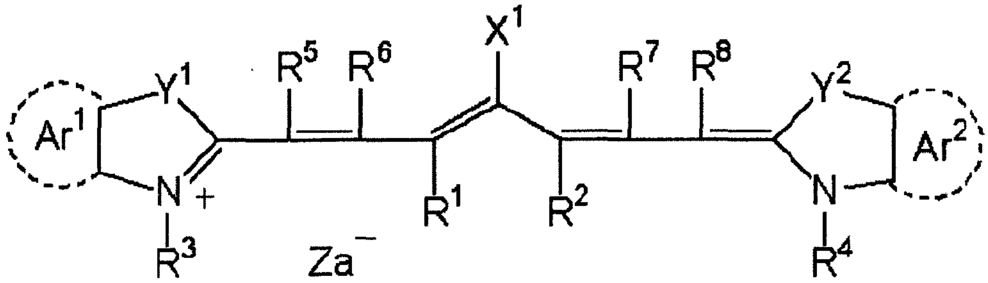

In General Formula (a), $X^1$ represents a hydrogen atom, a halogen atom, $-N(R^9)(R^{10})$, $-X^2-L^1$, or groups shown below. Here, $R^9$ and $R^{10}$ may be identical to or different from each other, and represent an aryl group having 6 to 10 carbon atoms that may have a substituent, an alkyl group having 1 to 8 carbon atoms, and a hydrogen atom. Alternately, $R^9$ and $R^{10}$ may be bonded to each other, to form a ring. Among these, a phenyl group is preferable ($-NPh_2$). $X^2$ represents an oxygen atom or a sulfur atom, and $L^1$ represents a hydrocarbon group having 1 to 12 carbon atoms and a hydrocarbon group having 1 to 12 carbon atoms which contains a heteroaryl group and a heteroatom. Here, the heteroatom represents N, S, O, a halogen atom, and Se. In the groups shown below, $Xa^-$ is defined in the same manner as $Za^-$ as described below, and Ra represents a substituent selected from a hydrogen atom, an alkyl group, an aryl group, a substituted or unsubstituted amino group, and a halogen atom.

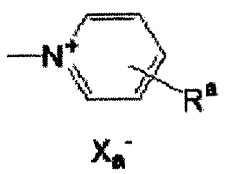

$R_1$ and $R_2$ each independently represent a hydrocarbon group having 1 to 12 carbon atoms. In view of storage stability of an image recording layer coating liquid, $R^1$ and $R^2$ each are preferably a hydrocarbon group having 2 or more carbon atoms. In addition, $R^1$ and $R^2$ may be linked to each other to form a ring, and when forming a ring, it is particularly preferable to form a 5-membered ring or a 6-membered ring.

$Ar^1$ and $Ar^2$ may be identical to or different from each other, and each represents an aryl group that may have a substituent. Preferred examples of an aryl group include a benzene ring and a naphthalene ring. In addition, preferred examples of a substituent include a hydrocarbon group having 12 or less carbon atoms, a halogen atom, and an alkoxy group having 12 or less carbon atoms. $Y^1$ and $Y^2$ may be identical to or different from each other, and each represents a sulfur atom or a dialkyl methylene group having 12 or less carbon atoms. $R^3$ and $R^4$ may be identical to or different from each other, and each represents a hydrocarbon group having 20 or less carbon atoms that may have a substituent. Preferred examples of a substituent include an alkoxy group having 12 or less carbon atoms, a carboxy group, and a sulfo group. $R^5$, $R^6$, $R^7$, and $R^8$ may be identical to or different from each other, and each represents a hydrogen atom

or a hydrocarbon group having 12 or less carbon atoms. In view of ease of acquisition of raw materials, a hydrogen atom is preferable. In addition, $Za^-$ represents a counter anion. However, if a cyanine coloring matter represented by General Formula (a) has an anionic substituent in a structure thereof and charges are not required to be neutralized, $Za^-$ is not necessary. In view of storage stability of an image recording layer coating liquid, preferred examples of $Za^-$ include a halide ion, a perchlorate ion, a tetrafluoroborate ion, a hexafluorophosphate ion, and a sulfonate ion, and particularly preferred examples thereof include a perchlorate ion, a hexafluorophosphate ion, and an arylsulfonate ion.

Specific examples of the cyanine coloring matter expressed by General Formula (a) which can be preferably used include compounds disclosed in paragraphs [0017] to [0019] of JP2001-133969A, and compounds disclosed in paragraphs [0016] to [0021] of JP2002-023360A and paragraphs [0012] to [0037] of JP2002-040638A. Preferred examples thereof include compounds disclosed in paragraphs [0034] to [0041] of JP2002-278057A, and paragraphs [0080] to [0086] of JP2008-195018A, and most preferred examples thereof include compounds disclosed in paragraphs [0035] to [0043] of JP2007-90850A.

In addition, compounds disclosed in paragraphs [0008] and [0009] and JP1993-5005A (JP-H5-5005A) and paragraphs [0022] to [0025] of JP2001-222101A can also be preferably used.

As the pigments, it is possible to use commercially available pigments and pigments disclosed in color index (C.I.) handbook, "Latest Pigment Handbook" (edited by The Japan Society of Colour Material, published in 1977), "Latest Pigment Application Technology" (CMC Publishing Co., Ltd. published in 1986), and "Printing Ink Technology" (CMC Publishing Co., Ltd, published in 1984).

The particle diameter of a pigment is preferably 0.01 μm to 1 μm and more preferably 0.01 μm to 0.5 μm. Well-known dispersion technology used for ink manufacture, toner manufacture, and the like can be used for dispersing pigments. The details of the technology are disclosed in "Latest Pigment Application Technology" (CMC Publishing Co., Ltd. published in 1986).

Only one type of infrared absorber may be used or two or more types thereof may be used in combination.

The amount of the infrared absorber is preferably 0.05 parts by mass to 30 parts by mass, more preferably 0.1 parts by mass to 20 parts by mass, and particularly preferably 0.2 parts by mass to 10 parts by mass with respect to 100 parts by mass of the total solid content of the image recording layer.

<Polymerization Initiator>

The polymerization initiator is a compound which starts and promotes polymerization of a polymerizable compound. As the polymerization initiator, a well-known thermal polymerization initiator, a compound having a bond with small bonding/dissociating energy, a photopolymerization initiator, and the like can be used.

Specific examples of the polymerization initiator include (a) an organic halide, (b) a carbonyl compound, (c) an azo compound, (d) organic peroxide, (e) a metallocene compound, (f) an azide compound, (g) a hexaarylbiimidazole compound, (h) an organic borate compound, (i) a disulfone compound, (j) an oxime ester compound, and (k) an onium salt compound.

As (a) the organic halide, compounds disclosed in paragraphs [0022] and [0023] of JP2008-195018A are preferable.

As (b) the carbonyl compound, compounds disclosed in paragraph [0024] of JP2008-195018A are preferable.

As (c) the azo compound, for example, azo compounds disclosed in JP1996-108621A (JP-H8-108621A) and the like can be used.

As (d) the organic peroxide, for example, compounds disclosed in paragraph [0025] of JP2008-195018A are preferable.

As (e) the metallocene compound, for example, compounds disclosed in paragraph [0026] of JP2008-195018A are preferable.

Examples of (f) the azide compound include a compound such as 2,6-bis(4-azidobenzylidene)-4-methylcyclohexanone.

As (g) the hexaarylbiimidazole compound, for example, compounds disclosed in paragraph [0027] of JP2008-195018A are preferable.

Examples of (h) the organic borate compound include organic borate compounds disclosed in paragraph [0028] of JP2008-195018A.

Examples of (i) the disulfone compound include compounds disclosed in JP1986-166544A (JP-S61-166544A).

As (j) the oxime ester compound, for example, compounds disclosed in paragraphs [0028] to [0030] of JP2008-195018A are preferable.

Examples of (k) the onium salt compound include onium salts such as diazonium salts disclosed in S. I. Schlesinger, Photogr. Sci. Eng., 18, 387 (1974), T. S. Bal et al, Polymer, 21, 423 (1980) and JP1993-158230A (JP-H5-158230A), ammonium salts disclosed in US4,069,055A and JP1992-365049A (JP-H4-365049A), phosphonium salts disclosed in US4,069,055A and US4,069,056A, iodonium salts disclosed in EP104,143B US2008/0311520A,

JP1990-150848A (JP-H2-150848A), JP2008-195018A, or J. V. Crivello et al, Macromolecules, 10(6), 1307 (1977), sulfonium salts disclosed in EP370,693B, EP233,567B, EP297,443B, EP297,442B, US4,933,377A, US4,760,013A, US4,734,444A, US2,833,827A, DE2,904,626B, DE3,604,580B, and DE3,604,581B, selenonium salts disclosed in J. V. Crivello et al, J. Polymer Sci., Polymer Chem. Ed., 17, 1047 (1979), arsonium salts disclosed in C. S. Wen et al, Teh, Proc. Conf. Rad. Curing ASIA, p. 478, Tokyo, Oct (1988), and azinium salts disclosed in JP2008-195018A.

In the polymerization initiators, preferred compounds include onium salts, and among these, examples thereof include iodonium salts and sulfonium salts.

As an example of the iodonium salt, a diphenyliodonium salt is preferable, an electron donating group, for example, a diphenyliodonium salt substituted with an alkyl group or an alkoxyl group is particularly preferable, and an asymmetrical diphenyliodonium salt is most preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyl iodonium=hexafluorophosphate, 4-hexyloxy phenyl-2,4,6-trimethoxyphenyliodonium=hexafluorophosphate, 4-hexyloxyphenyl-2,4-diethoxyphenyliodonium=tetrafluoroborate, 4-octyloxyphenyl-2,4,6-trimethoxyphenyliodonium=1-perfluorobutanesulfonate, 4-octyloxyphenyl-2,4,6-trimethoxyphenyliodonium=hexafluorophosphate, and bis(4-t-butylphenyl)iodonium=tetraphenylborate.

Examples of the sulfonium salts include triphenylsulfonium=hexafluorophosphate, triphenylsulfonium=benzoyl formate, bis(4-chlorophenyl)phenylsulfonium=benzoyl formate, bis(4-chlorophenyl)-4-methylphenylsulfonium=tetrafluoroborate, tris(4-chlorophenyl)sulfonium=3,5-bis(methoxycarbonyl)benzenesulfonate, and tris(4-chlorophenyl)sulfonium=hexafluorophosphate.

In addition, the organic borate compound can also be preferably used. Specific examples of the organic borate compound include tetraphenylborate salts, tetratolylborate salts, tetrakis(4-methoxyphenyl)borate salts, tetrakis(pentafluorophenyl)borate salts, tetrakis(3,5-bis(trifluoromethyl)phenyl)borate salts, tetrakis(4-chlorophenyl)borate salts, tetrakis(4-fluorophenyl)borate salts, tetrakis(2-thienyl)borate salts, tetrakis(4-phenyl-phenyl)borate salts, tetrakis(4-t-butylphenyl)borate salts, ethyltriphenylborate salts, and butyltriphenylborate salts. In view of compatibility between printing durability, tone reproducibility and temporal stability, tetraphenylborate salts are preferable. Examples of counter cations of borate compound include well-known cations, such as alkaline metal cations, alkaline earth metal cations, ammonium cations, phosphonium cations, sulfonium cations, iodonium cations, diazonium cations, and azinium cations.

The content of the polymerization initiator is preferably 0.1 mass% to 50 mass%, more preferably 0.5 mass% to 30 mass%, and particularly preferably 0.8 mass% to 20 mass% with respect to the total solid content of the image recording layer. In this range, more favorable sensitivity and more favorable stain resistance of a non-image portion during printing can be obtained.

<Polymerizable Compound>

The polymerizable compound is an addition-polymerizable compound having at least one ethylenically unsaturated double bond, and can be selected from a compound having at least one and preferably two or more terminal ethylenically unsaturated bonds. These compounds have, for example, a chemical form of a monomer, a prepolymer, that is, a dimer, a trimer, and an oligomer, or a mixture thereof.

Examples of the monomer include unsaturated carboxylic acids (for example, an acrylic acid, a methacrylic acid, an itaconic acid, a crotonic acid, an isocrotonic acid, and a maleic acid), esters thereof, and amides thereof. An ester between an unsaturated carboxylic acid and a polyhydric alcohol compound; amides between an unsaturated carboxylic acid and a polyvalent amine compound are preferably used. In addition, an addition-reaction product of an unsaturated carboxylic ester or amides having a nucleophilic substituent such as a hydroxy group, an amino group, or a mercapto group, with monofunctional or multifunctional isocyanates or epoxies; a dehydration condensation reaction product thereof with a monofunctional or multifunctional carboxylic acid, and the like are also suitably used. An addition-reaction product of an unsaturated carboxylic ester or amides having an electrophilic substituent such as an isocyanate group or an epoxy group, with monofunctional or multifunctional alcohols, amines, or thiols; or a substitution-reaction product of an unsaturated carboxylic ester or amides having a dissociative substituent such as a halogen group or a tosyloxy group, with monofunctional or multifunctional alcohols, amines or thiols are also suitable.

In addition, as other examples, compound groups in which the above-described unsaturated carboxylic acid is replaced with an unsaturated phosphonic acid, styrene, vinyl ether, or the like can be used. These are disclosed in reference documents including JP2006-508380A, JP2002-287344A, JP2008-256850A, JP2001-342222A, JP1997-179296A (JP-H9-179296A), JP1997-179297A (JP-H9-179297A), JP1997-179298A (JP-H9-179298A), JP2004-294935A, JP2006-243493A, JP2002-275129A, JP2003-64130A, JP2003-280187A, and JP1998-333321A (JP-H10-333321A).

Specific examples of a monomer of the ester between a polyhydric alcohol compound and an unsaturated carboxylic acid include, as an acrylic acid ester, ethylene glycol diacrylate, 1,3-butanediol diacrylate, tetramethylene glycol diacrylate, propylene glycol diacrylate, trimethylol propane triacrylate, hexane diol diacrylate, tetraethylene glycol

diacrylate, pentaerythritol tetraacrylate, sorbitol triacrylate, isocyanuric acid ethylene oxide (EO)-modified triacrylate, and a polyester acrylate oligomer. Examples of the methacrylic acid ester include tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane, and bis-[p-(methacryloxyethoxy)phenyl]dimethylmethane. In addition, specific examples of a monomer of the amide between a polyvalent amine compound and an unsaturated carboxylic acid include methylene bis-acrylamide, methylene bis-methacrylamide, 1,6-hexamethylene bis-acrylamide, 1,6-hexamethylene bis-methacrylamide, diethylene triamine trisacrylamide, xylylene bisacrylamide, and xylylene bismethacrylamide.

In addition, a urethane-based addition-polymerizable compound produced by an addition reaction between isocyanate and a hydroxyl group is also suitable. Specific examples thereof include a vinyl urethane compound containing two or more polymerizable vinyl groups in one molecule in which a vinyl monomer containing a hydroxy group represented by the following General Formula (b) is added to a polyisocyanate compound having two or more isocyanate groups in one molecule disclosed in JP1973-41708B (JP-S48-41708B).

$$CH_2=C(R^4)COOCH_2CH(R^5)OH \qquad (b)$$

(However, each of $R^4$ and $R^5$ independently represents H or $CH_3$.)

In addition, urethane acrylates disclosed in JP1976-37193A (JP-S51-37193A), JP1990-32293B (JP-H2-32293B), JP1990-16765B (JP-H2-16765B), JP2003-344997A, and JP2006-65210A, urethane compounds having an ethylene oxide-based skeleton disclosed in JP1983-49860B (JP-S58-49860B), JP1981-17654B (JP-S56-17654B), JP1987-39417B (JP-S62-39417B), JP1987-39418B (JP-S62-39418B), JP2000-250211A, and JP2007-94138A, and urethane compounds having hydrophilic groups disclosed in US7,153,632B, JP1996-505958A (JP-H8-505958A), JP2007-293221A, and JP2007-293223A are also suitable.

Among the above-described compounds, from the viewpoint of excellent balance between hydrophilicity involved in on-press developability and polymerization ability involved in printing durability, isocyanuric acid ethylene oxide-modified acrylates such as tris(acryloyloxyethyl)isocyanurate and bis(acryloyloxyethyl)hydroxyethyl isocyanurate are particularly preferable.

Details of usage methods such as structures of the polymerizable compounds, single use or combined use thereof, or addition amounts of the polymerizable compounds can be arbitrarily set according to the performance design of the final lithographic printing plate precursor. The polymerizable compound is used within a preferable range of 5 mass% to 75 mass%, more preferable range of 10 mass% to 70 mass%, and particularly preferable range of 15 mass% to 60 mass% with respect to the total solid content of the image recording layer.

<Binder Polymer>

A binder polymer can be mainly used for the purpose of enhancing the film strength of the image recording layer. As the binder polymer, any well-known binder polymer in the related art can be used, and a polymer having coating properties is preferable. Among these, an acrylic resin, a polyvinyl acetal resin, a polyurethane resin, and the like are preferable.

Examples of the suitable binder polymer include a binder polymer which has a crosslinkable functional group for enhancing the coating strength of an image portion disclosed in JP2008-195018A, in a main chain or a side chain, and preferably in a side chain. A crosslink is formed between polymer molecules using the crosslinkable group, and curing is promoted.

As the crosslinkable functional group, an ethylenically unsaturated group such as a (meth)acryloyl group, a vinyl group, an allyl group, or a styryl group, an epoxy group, or the like is preferable, and crosslinkable functional groups can be introduced into a polymer through a polymer reaction or copolymerization. For example, it is possible to use a reaction between glycidyl methacrylate and polyurethane or an acrylic polymer which has a carboxy group in a side chain; or a reaction between an ethylenically unsaturated group-containing carboxylic acid such as a methacrylic acid and a polymer which has an epoxy group.

The content of the crosslinkable group in a binder polymer is preferably 0.1 mmol to 10.0 mmol, more preferably 0.25 mmol to 7.0 mmol, and most preferably 0.05 mmol to 5.5 mmol, per 1 g of the binder polymer.

In addition, it is preferable that the binder polymer has a hydrophilic group. The hydrophilic group contributes to provision of on-press developability to the image recording layer. Particularly, the printing durability and the on-press developability can be made compatible due to coexistence of the crosslinkable group and the hydrophilic group.

Examples of the hydrophilic group include hydroxy group, a carboxy group, an alkylene oxide structure, an amino group, an ammonium group, an amido group, a sulfo group, and a phosphoric acid group. Among these, an alkylene oxide structure having 1 to 9 alkylene oxide units having 2 or 3 carbon atoms is preferable. A monomer having a hydrophilic group may be copolymerized in order to provide a binder polymer with a hydrophilic group.

In addition, it is possible to introduce a lipophilic group such as an alkyl group, an aryl group, an aralkyl group, or an alkenyl group into the binder polymer in order to control depositing properties. For example, a lipophilic group-containing monomer such as a methacrylic acid alkyl ester may be copolymerized.

The mass average molar mass (Mw) of the binder polymer is preferably greater than or equal to 2,000, more preferably greater than or equal to 5,000, and still more preferably 10,000 to 300,000.

The content of the binder polymer is suitably 3 mass% to 90 mass%, preferably 5 mass% to 80 mass%, and more preferably 10 mass% to 70 mass% with respect to the total solid content of the image recording layer.

Preferred examples of the binder polymer include a polymer compound having polyoxyalkylene chain in a side chain. Permeability of dampening water is promoted and on-press developability is improved by making the image recording layer contain the polymer compound (hereinafter, also referred to as a specific polymer compound) having polyoxyalkylene chain in a side chain.

Examples of a resin constituting a main chain of the specific polymer compound include an acrylic resin, a polyvinyl acetal resin, a polyurethane resin, a polyurea resin, a polyimide resin, a polyamide resin, an epoxy resin, a methacrylic resin, a polystyrene-based resin, a novolac-type phenolic resin, a polyester resin, synthetic rubber, and natural rubber, and an acrylic resin is particularly preferable.

The specific polymer compound does not substantially contain a perfluoroalkyl group. The expression that "a perfluoroalkyl group is not substantially contained" means that the mass ratio of a fluorine atom which exists as a perfluoroalkyl group in a polymer compound is smaller than 0.5 mass%, and it is preferable that the polymer compound does not contain a perfluoroalkyl group. The mass ratio of a fluorine atom can be measured through an element analysis method.

In addition, the "perfluoroalkyl group" is a group in which all hydrogen atoms of an alkyl group is substituted with fluorine atoms.

As alkylene oxide (oxyalkylene) in a polyoxyalkylene chain, alkylene oxide having 2 to 6 carbon atoms is preferable, ethylene oxide (oxyethylene) or propylene oxide (oxypropylene) is more preferable, and ethylene oxide is still more preferable.

The number of repetitions of the alkylene oxide in a polyoxyalkylene chain, that is, a poly(alkylene oxide) moiety is preferably 2 to 50 and more preferably 4 to 25.

If the number of repetitions of alkylene oxide is greater than or equal to 2, the permeability of dampening water is sufficiently improved, which is preferable. If the number of repetitions thereof is less than or equal to 50, printing durability by abrasion is not decreased, which is preferable.

The poly(alkylene oxide) moiety is preferably contained in a structure represented by the following General Formula (1) as a side chain of the polymer compound. The poly(alkylene oxide) moiety is more preferably contained in a structure represented by the following General Formula (1) as a side chain of the acrylic resin.

General Formula (1)

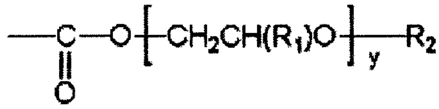

In General Formula (1), y represents a range of 2 to 50 and more preferably a range of 4 to 25. $R_1$ represents a hydrogen atom or an alkyl group, and $R_2$ represents a hydrogen atom or an organic group. As the organic group, an alkyl group having 1 to 6 carbon atoms is preferable, and examples thereof include a methyl group, an ethyl group, an n-propyl group, an isopropyl group, an n-butyl group, a sec-butyl group, an isobutyl group, a t-butyl group, a n-pentyl group, an isopentyl group, a neopentyl group, an n-hexyl group, an isohexyl group, a 1,1-dimethylbutyl group, a 2,2-dimethylbutyl group, a cyclopentyl group, and a cyclohexyl group.

In General Formula (1), $R_1$ is preferably a hydrogen atom or a methyl group, and a hydrogen atom is particularly preferable. $R_2$ is particularly preferably a hydrogen atom or a methyl group.

The specific polymer compound may have crosslinking properties in order to enhance the coating strength of the image portion. In order to cause the polymer compound to have crosslinking properties, a crosslinkable functional group such as an ethylenically unsaturated bond may be introduced into a main chain or a side chain of a polymer. The crosslinkable functional group may be introduced through copolymerization.

Examples of the polymer compound having an ethylenically unsaturated bond in a main chain of a molecule include poly-1,4-butadiene and poly-1,4-isoprene.

Examples of the polymer compound having an ethylenically unsaturated bond in a side chain of a molecule include a polymer compound of an ester or an amide of an acrylic acid or a methacrylic acid and a polymer compound in which a residue (R of -COOR or CONHR) of an ester or an amide has an ethylenically unsaturated bond.

Examples of the residue (the above-described R) having an ethylenically unsaturated bond include

$-(CH_2)_nCR^1=CR^2R^3$, $-(CH_2O)_nCH_2CR^1=CR^2R^3$, $-(CH_2CH_2O)_nCH_2CR^1=CR^2R^3$, $-(CH_2)_nNH-CO-O-CH_2CR^1=CR^2R^3$, $-(CH_2)_n-O-CO-CR^1=CR^2R^3$, and $(CH_2CH_2O)_2-X$ (where $R^1$ to $R^3$ respectively represent a hydrogen atom; a halogen atom, or an alkyl group, an aryl group, an alkoxy group, or an aryloxy group having 1 to 20 carbon atoms; $R^1$ and $R^2$ or $R^3$ may be bonded to each other to form a ring; n represents an integer of 1 to 10; and X represents a dicyclopentadienyl residue).

Specific examples of the ester residue include $-CH_2CH=CH_2$ (disclosed in JP1995-21633B (JP-H7-21633B)), $-CH_2CH_2O-CH_2CH=CH_2$, $-CH_2C(CH_3)=CH_2$, $-CH_2CH=CH-C_6H_5$, $-CH_2CH_2OCOCH=CH-C_6H_5$, $-CH_2CH_2-NHCOO-CH_2CH=CH_2$, and $CH_2CH_2O-X$ (where X represents a dicyclopentadienyl residue).

Specific examples of the amide residue include $-CH_2CH=CH_2$, $-CH_2CH_2-Y$ (where Y represents a cyclohexane residue), and $-CH_2CH_2-OCO-CH=CH_2$.

The specific polymer compound having the crosslinking properties is cured by adding a free radical (a propagation radical in a polymerization process of a polymerization initiation radical or a polymerizable compound) to a crosslinkable functional group thereof, performing addition-polymerization directly between polymer compounds or through a polymerization chain of the polymerizable compound, and forming a crosslink between polymer compound molecules. Alternately, the specific polymer compound is cured by extracting an atom (for example, a hydrogen atom on a carbon atom adjacent to a crosslinkable functional group) in a polymer compound using a free radical, generating polymer compound radicals, bonding the polymer compound radicals to each other, and forming a crosslink between polymer compound molecules.

The content of the crosslinkable group in a specific polymer compound (the content of an unsaturated double bond that can perform radical polymerization by iodine titration) is preferably 0.1 mmol to 10.0 mmol, more preferably 1.0 mmol to 7.0 mmol, and particularly preferably 2.0 mmol to 5.5 mmol per 1 g of the polymer compound. In this range, favorable sensitivity and favorable storage stability can be obtained.

The specific polymer compound may further contain a copolymerization component for the purpose of improving various types of performance such as the image strength as long as it does not impair the original effect of the specific polymer compound. Preferred examples of the copolymerization component include a component represented by the following General Formula (2).

General Formula (2) 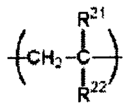

In General Formula (2), $R^{21}$ represents a hydrogen atom or a methyl group. $R^{22}$ represents a substituent.

Preferred examples of $R^{22}$ include an ester group, an amido group, a cyano group, a hydroxy group, or an aryl group. Among these, an ester group, an amido group, or a phenyl group which may have a substituent is preferable. Examples of the substituent of a phenyl group include an alkyl group, an aralkyl group, an alkoxy group, and an acetoxymethyl group.

Examples of the copolymerization component represented by General Formula (2) include acrylic acid esters, methacrylic acid esters, acrylamides, methacrylamides, N-substituted acrylamides, N-substituted methacrylamides, N,N-2-substituted acrylamides, N,N-2-substituted methacrylamides, styrenes, acrylonitriles, and methacrylonitriles. Preferred examples thereof include acrylic acid esters, methacrylic acid esters, acrylamides, methacrylamides, N-substituted acrylamides, N-substituted methacrylamides, N,N-2-substituted acrylamides, N,N-2-substituted methacrylamides, and styrenes. Acrylonitriles are preferable from the viewpoint of printing durability.

The ratio of a repeating unit having a poly(alkylene oxide) moiety with respect to total repeating units constituting the specific polymer compound is not particularly limited, but is preferably 0.5 mol% to 80 mol% and more preferably 0.5 mol% to 50 mol%.

Specific Examples A-1 to A-19 of specific polymer compounds will be shown below, but the present invention is not limited thereto. The repeating unit ratio is a molar ratio.

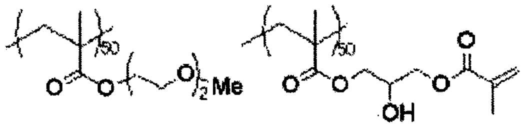

A-1 Mw 60,000

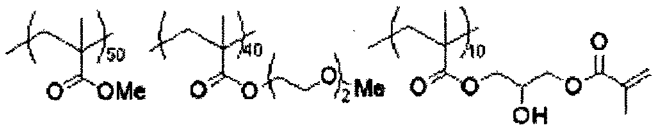

A-2 Mw 60,000

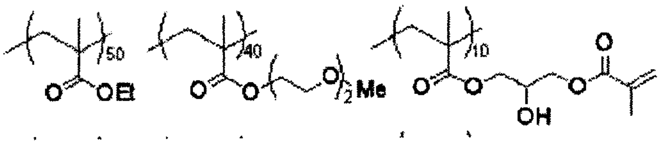

A-3 Mw 60,000

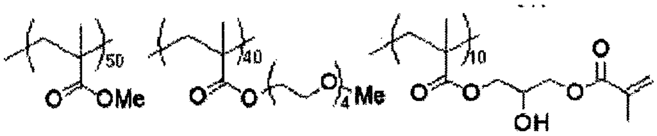

A-4 Mw 60,000

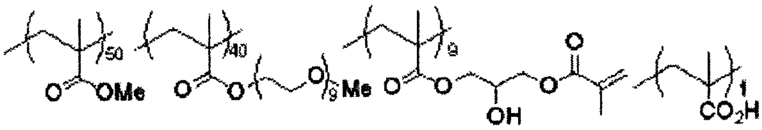

A-5 Mw 55,000

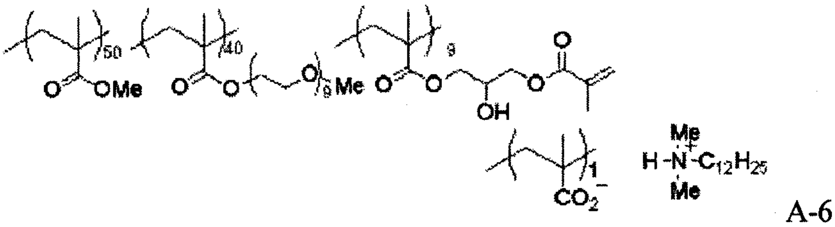

A-6 Mw 55,000

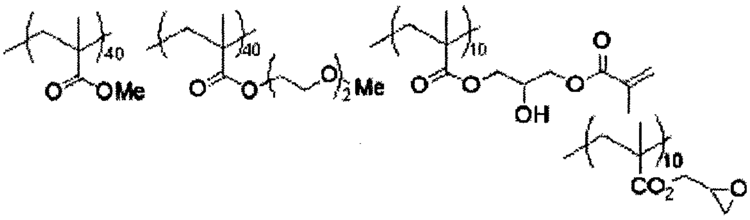

A-7 Mw 65,000

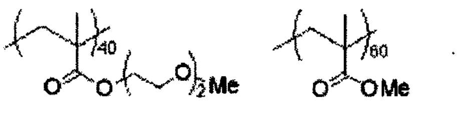

A-8 Mw 60,000

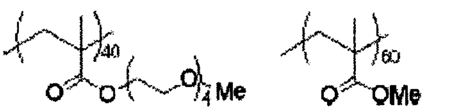

A-9 Mw 60,000

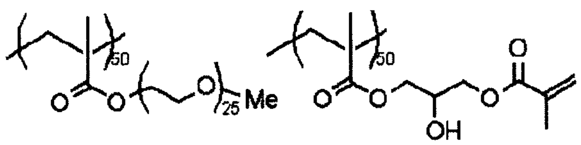

A-10 Mw 50,000

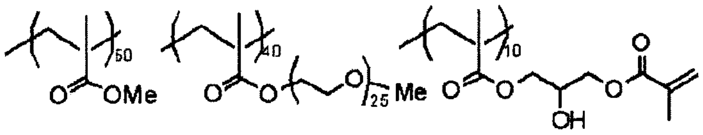

A-11 Mw 50,000

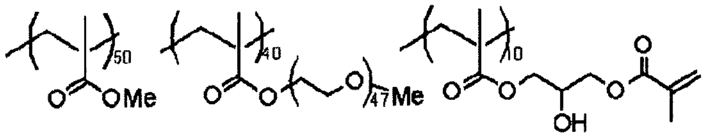

A-12 Mw 50,000

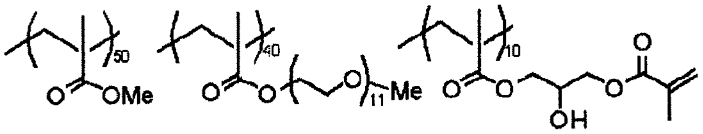

A-13 Mw 50,000

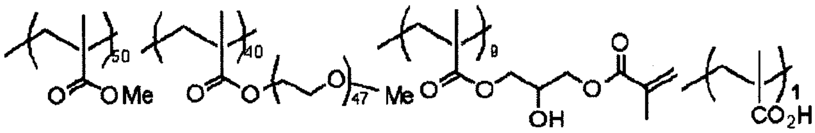

A-14 Mw 50,000

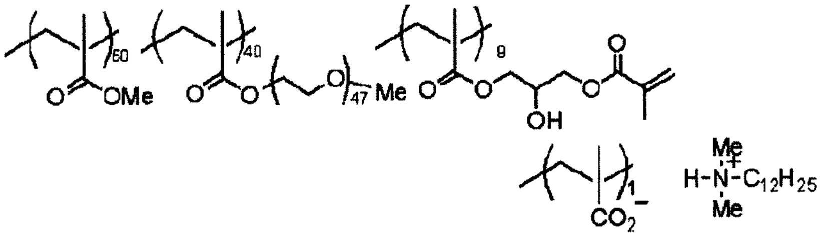

A-15 Mw 55,000

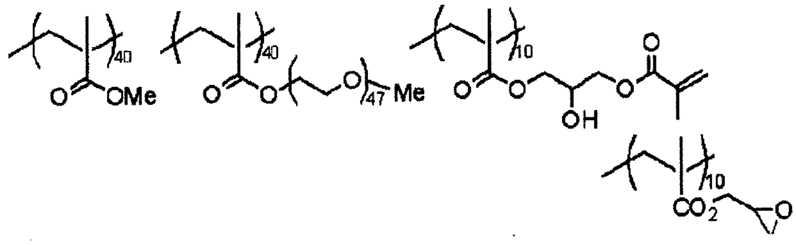

A-16 Mw 60,000

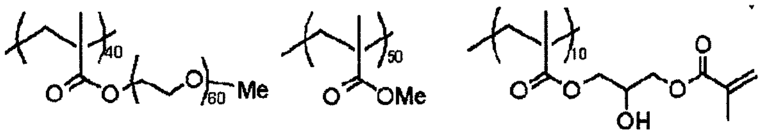

A-17 Mw 50,000

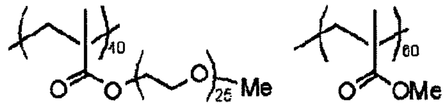

A-18 Mw 50,000

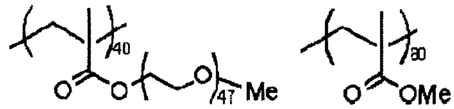

A-19 Mw 50,000

The specific polymer compound can be used with a hydrophilic polymer compound such as a polyacrylic acid and polyvinyl alcohol disclosed in JP2008-195018A in combination as necessary. In addition, a lipophilic polymer compound and a hydrophilic polymer compound may be used in combination.

The form of the specific polymer compound the image recording layer may exist as a binder that achieves a function of linking components of the image recording layer or may exist in a form of a fine particle. In a case where the specific polymer compound exists in a form of a fine particle, the average particle diameter is within a range of 10 nm to 1,000 nm, preferably within a range of 20 nm to 300 nm, and particularly preferably within a range of 30 nm to 120 nm.

The content of the specific polymer compound is preferably 3 mass% to 90 mass% and more preferably 5 mass% to 80 mass% with respect to the total solid content of the image recording layer. In the range of 3 mass% to 90 mass%, permeability of dampening water and image forming properties can be made more reliably compatible.

As another preferred examples of the binder polymer include a polymer compound (hereinafter, also referred to as a star-shaped polymer compound) which has a polymer chain bonded to a nucleus, as which a hexafunctional to decafunctional multifunctional thiol is used, through sulfide bonding, and in which the polymer chain has a polymerizable group. As the star-shaped polymer compound, for example, compounds disclosed in JP2012-148555A can be preferably used.

Examples of the star-shaped polymer compound include a star-shaped polymer compound which has a polymerizable group, such as an ethylenically unsaturated bond for enhancing the coating strength of an image portion as disclosed in JP2008-195018A, in a main chain or a side chain, and preferably in a side chain. A crosslink is formed between polymer molecules using the polymerizable group, and curing is promoted.

As the polymerizable group, an ethylenically unsaturated group such as a (meth)acrylic group, a vinyl group, an allyl group, or a styryl group, an epoxy group, or the like is preferable, a (meth)acrylic group, a vinyl group, or a styryl group are more preferable from the viewpoint of polymerization reactivity, and a (meth)acrylic group is particularly preferable. These groups can be introduced into a polymer through a polymer reaction or copolymerization. For example, it is possible to use a reaction between glycidyl methacrylate and a polymer which has a carboxy group in a side chain; or a reaction between an ethylenically unsaturated group-containing carboxylic acid such as a methacrylic acid and a polymer which has an epoxy group. These groups may be used in combination.

The content of the crosslinkable group in a star-shaped polymer compound is preferably 0.1 mmol to 10.0 mmol, more preferably 0.25 mmol to 7.0 mmol, and most preferably 0.5 mmol to 5.5 mmol, per 1 g of the star-shaped polymer compound.

In addition, it is preferable that the star-shaped polymer compound further has a hydrophilic group. The hydrophilic group contributes to provision of on-press developability to the image recording layer. Particularly, the printing durability and the developability can be made compatible due to coexistence of the polymerizable group and the hydrophilic group.

Examples of the hydrophilic group include $-SO_3M^1$, -OH, $-CONR^1R^2$ ($M^1$ represents a metal ion, an ammonium ion, or a phosphonium ion; $R^1$ and $R^2$ each independently represent a hydrogen atom, an alkyl group, an alkenyl group, or an aryl group; and $R^1$ and $R^2$ may be bonded to each other to form a ring), $-N+R^3R^4R^5X-$ ($R^3$ to $R^5$ each independently represent an alkyl group having 1 to 8 carbon atoms; and $X^-$ represents an counter anion), a group represented by the following General Formula (1) and a group represented by the following General Formula (2).

$-(CH_2CH_2O)_nR$ General Formula (1)

$-(C_3H_6O)_mR$ General Formula (2)

In the above formulas, n and m each independently represent an integer of 1 to 100 and Rs each independently represent a hydrogen atom or an alkyl group having 1 to 18 carbon atoms.

Here, in a case where the star-shaped polymer compound is a star-shaped polymer compound which has a polyoxyalkylene chain (for example, a group represented by the above-described General Formula (1) or (2)) in a side chain, such a star-shaped polymer compound is also a polymer compound which has the polyoxyalkylene chain in a side chain.

Among these hydrophilic groups, $-CONR^1R^2$, a group represented by General Formula (1), and a group represented by General Formula (2) are preferable, $-CONR^1R^2$ and a group represented by General Formula (1) are more preferable, and a group represented by General Formula (1) is particularly preferable. Furthermore, in the group represented by General Formula (1), n is more preferably 1 to 10 and particularly preferably 1 to 4. In addition, R is more preferably a hydrogen atom or an alkyl group having 1 to 4 carbon atoms and is particularly preferably a hydrogen atom or a methyl group. Two or more types of these hydrophilic groups may be used in combination.

In addition, it is preferable that the star-shaped polymer compound does not substantially have a carboxylic acid group, a phosphoric acid group, and a phosphonic acid group. Specifically, less than 0.1 mmol/g is preferable, less than 0.05 mmol/g is more preferable, and less than or equal to 0.03 mmol/g is particularly preferable. If the proportion

of these acid groups is less than 0.1 mmol/g, the developability is more improved.

In addition, it is possible to introduce a lipophilic group such as an alkyl group, an aryl group, an aralkyl group, or an alkenyl group into the star-shaped polymer compound in order to control depositing properties. Specifically, a lipophilic group-containing monomer such as a methacrylic acid alkyl ester may be copolymerized.

Specific examples of the star-shaped polymer compound will be shown below, but the present invention is not limited thereto. In the following Tables, structures corresponding to respective numbers of central nuclei are structures disclosed in paragraphs [0021] to [0040] in JP2012-148555A. In all of the following specific examples, hexa- to decafunctional multifunctional thiols are used as nuclei, but the present invention is not limited thereto. For example, the central nuclei may be penta- or less functional multifunctional thiols.

[Table 1]

| Polymer number | Central nucleus | | Polymer chain | | | | | | Mw |
|---|---|---|---|---|---|---|---|---|---|
| | Number | Mol %*1 | Polymerizable group | Mol % | Hydrophilic group | Mol % | Others | Mol % | |
| P-1 | SB-2 | 1 | 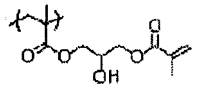 | 10 | 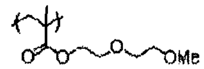 | 40 | 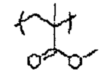 | 50 | 65,000 |
| P-2 | SB-2 | 1 | 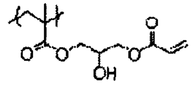 | 10 | 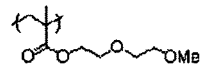 | 40 | 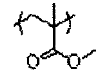 | 50 | 64,000 |
| P-3 | SB-2 | 1 | 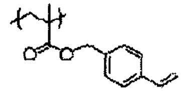 | 10 | 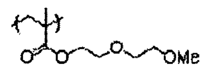 | 40 | 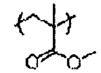 | 50 | 62,000 |
| P-4 | SB-2 | 1 | 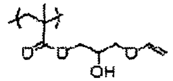 | 10 | 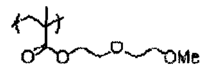 | 40 | 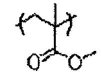 | 50 | 66,000 |
| P-5 | SB-2 | 1 | 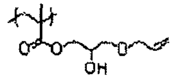 | 10 | 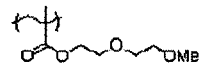 | 40 | 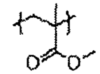 | 50 | 67,000 |
| P-6 | SB-2 | 1 | 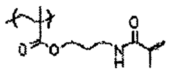 | 10 | 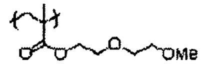 | 40 | 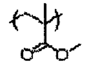 | 50 | 69,000 |
| P-7 | SB-2 | 1 | 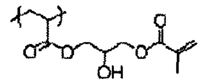 | 10 | 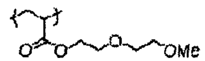 | 40 | 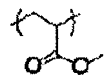 | 50 | 61,000 |
| P-8 | SB-2 | I | 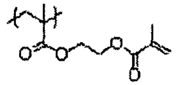 | 10 | 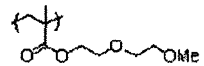 | 40 | 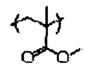 | 50 | 71,000 |
| P-9 | SB-2 | 1 | 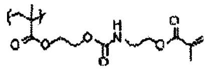 | 10 | 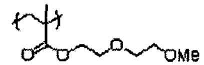 | 50 | 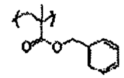 | 40 | 66,000 |
| P-10 | SB-2 | 1 | 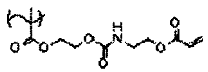 | 10 | 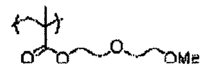 | 50 | 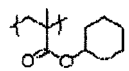 | 40 | 62,000 |

(continued)

| Polymer number | Central nucleus | | Polymer chain | | | | | | Mw |
|---|---|---|---|---|---|---|---|---|---|
| | Number | Mol %*1 | Polymerizable group | Mol % | Hydrophilic group | Mol % | Others | Mol % | |
| P-11 | SB-2 | 1 | 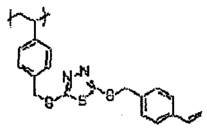 | 10 | 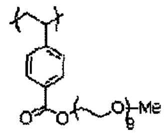 | 60 | 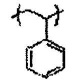 | 30 | 58,000 |
| P-12 | SB-2 | 1 | 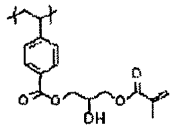 | 10 | 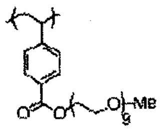 | 60 | 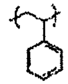 | 30 | 57,000 |
| P-13 | SB-2 | 1 | 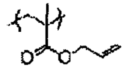 | 10 | 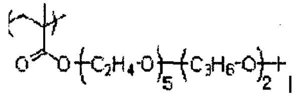 | 50 | 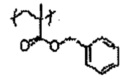 | 40 | 78,000 |
| P-14 | SB-2 | 1 | 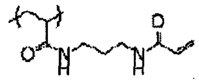 | 10 | 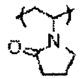 | 40 | 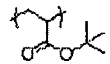 | 50 | 70,000 |

*1: Ratio (%) of number of moles of SH group to number of total moles of monomer

[Table 2]

| Polymer number | Central nucleus | | Polymer chain | | | | | | Mw |
|---|---|---|---|---|---|---|---|---|---|
| | Number | Mol% *2 | Polymerizable group | Mol % | Hydrophilic group | Mol % | Others | Mol % | |
| P-15 | SB-2 | 1 | 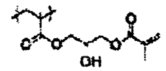 | 5 | 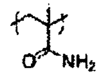 | 8 | 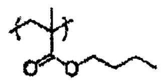 | 87 | 63,000 |
| P-16 | SB-2 | 1 | 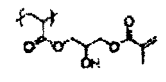 | 5 | 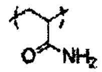 | 6 | 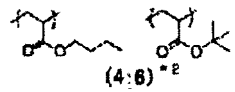 (4:6) *2 | 89 | 64,000 |
| P-17 | SB-2 | 1 | 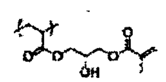 | 5 | 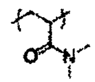 | 10 | 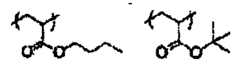 (4:6) *2 | 85 | 61,000 |
| P-18 | SB-2 | 1 | 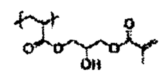 | 5 | 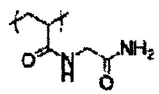 | 5 | 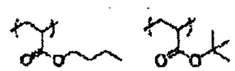 (4:6) *2 | 90 | 59,000 |
| P-19 | SB-2 | 1 | 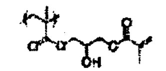 | 5 | 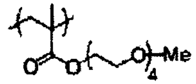 | 26 | 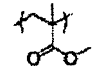 | 69 | 72,000 |
| P-20 | SB-2 | 1 | 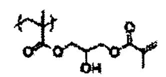 | 5 | 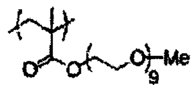 | 12 | 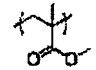 | 83 | 71,000 |
| P-21 | SB-2 | 1 | 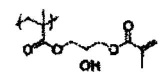 | 5 | 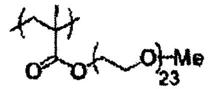 | 8 | 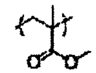 | 87 | 69,000 |
| P-22 | SB-2 | 1 | 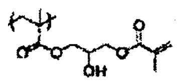 | 5 | 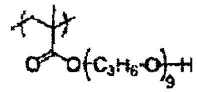 | 15 | 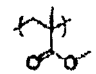 | 80 | 67,000 |
| P-23 | SB-2 | 1 | 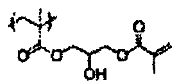 | 5 | 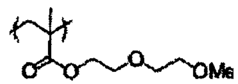 | 52 | 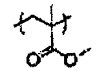 | 43 | 73,000 |

*1: Ratio (%) of number of moles of SH group to number of total moles of monomer
*2: The inside of ( ) represents each molar ratio of unit.

[Table 3]

| Polymer number | Central nucleus | | Polymer chain | | | | | | Mw |
|---|---|---|---|---|---|---|---|---|---|
| | Number | Mol%*1 | Polymerizable group | Mol% | Hydrophilic group | Mol% | Others | Others | |
| P-24 | SB-1 | 1 | 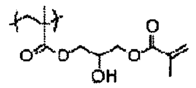 | 5 | 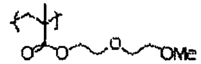 | 52 | 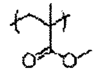 | 43 | 67,000 |
| P-25 | SB-3 | 1 | 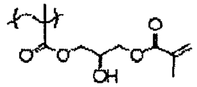 | 5 | 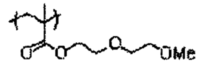 | 52 | 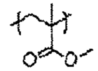 | 43 | 62,000 |
| P-26 | SB-4 | 1 | 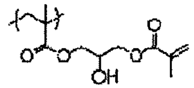 | 5 | 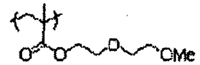 | 62 | 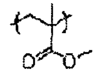 | 43 | 66,000 |
| P-27 | SB-5 | 1 | 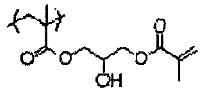 | 5 | 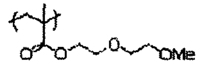 | 52 | 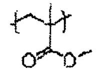 | 43 | 66,000 |
| P-28 | SB-6 | 1 | 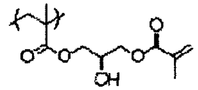 | 5 | 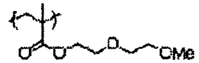 | 52 | 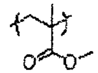 | 43 | 65,000 |
| P-29 | SB-7 | 0.6 | 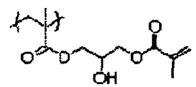 | 5 | 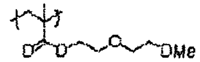 | 52 | 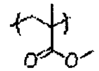 | 43 | 71,000 |
| P-30 | SB-8 | 0.6 | 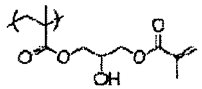 | 5 | 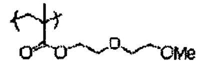 | 52 | 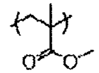 | 43 | 71,000 |
| P-31 | SB-9 | 0.6 | 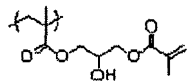 | 5 | 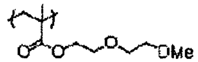 | 52 | 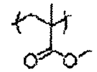 | 43 | 67,000 |
| P-32 | SB-10 | 0.6 | 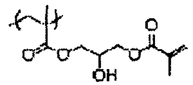 | 5 | 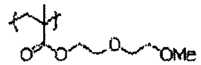 | 52 | 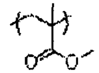 | 43 | 63,000 |

(continued)

| Polymer number | Central nucleus | | Polymer chain | | | | | | Mw |
|---|---|---|---|---|---|---|---|---|---|
| | Number | Mol%*1 | Polymerizable group | Mol% | Hydrophilic group | Mol% | Others | Others | |
| P-33 | SB-11 | 0.6 | 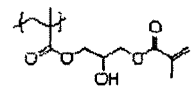 | 5 | 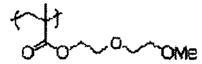 | 52 | 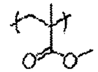 | 43 | 65,000 |
| P-34 | SB-12 | 0.6 | 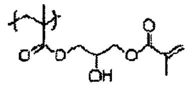 | 5 | 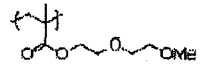 | 52 | 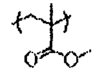 | 43 | 66,000 |
| P-35 | SB-14 | 1 | 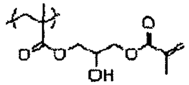 | 5 | 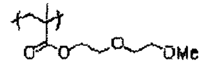 | 52 | 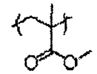 | 43 | 62,000 |
| P-36 | SB-16 | 1 | 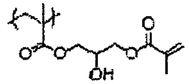 | 5 | 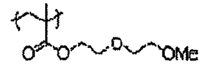 | 52 | 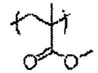 | 43 | 61,000 |
| P-37 | SB-16 | 1 | 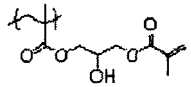 | 5 | 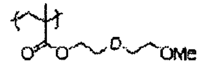 | 52 | 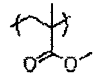 | 43 | 63,000 |
| P-38 | SB-17 | 1 | 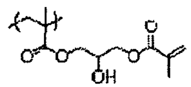 | 5 | 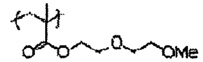 | 52 | 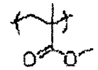 | 43 | 64,000 |
| P-39 | SB-20 | 1 | 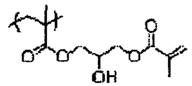 | 5 | 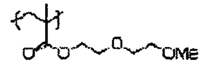 | 52 | 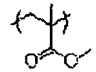 | 43 | 63,000 |

*1: Ratio (%) of number of moles of SH group to number of total moles of monomer

[Table 4]

| Polymer number | Central nucleus | | Polymer chain | | | | | | Mw |
|---|---|---|---|---|---|---|---|---|---|
| | Number | Mol%[*1] | Polymerizable group | Mol% | Hydrophilic group | Mol% | Others | Mol% | |
| P-40 | SB-26 | 1 | 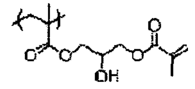 | 5 | 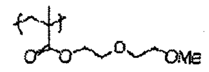 | 52 | 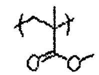 | 43 | 63,000 |
| P-41 | SB-32 | 1 | 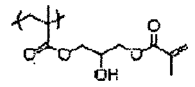 | 5 | 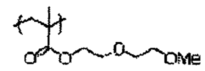 | 52 | 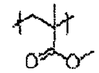 | 43 | 62,000 |
| P-42 | SB-38 | 1 | 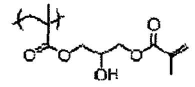 | 5 | 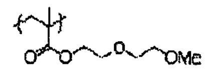 | 52 | 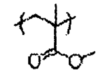 | 43 | 63,000 |
| P-43 | SB-37 | 1 | 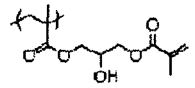 | 5 | 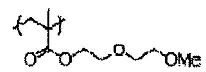 | 52 | 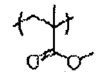 | 43 | 63,000 |
| P-44 | SC-1 | 1 | 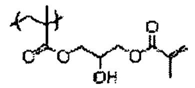 | 5 | 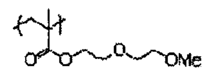 | 52 | 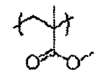 | 43 | 63,000 |
| P-45 | SC-2 | 1 | 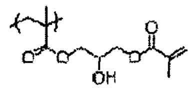 | 5 | 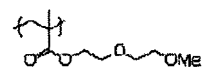 | 52 | 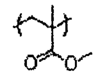 | 43 | 64,000 |
| P-46 | SC-4 | 1 | 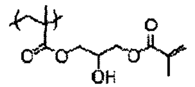 | 5 | 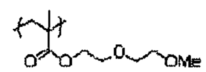 | 52 | 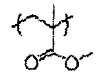 | 43 | 64,000 |
| P-47 | SC-5 | 1 | 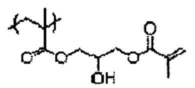 | 5 | 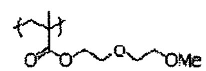 | 62 | 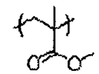 | 43 | 63,000 |
| P-48 | SD-2 | 0.8 | 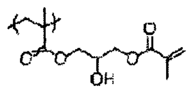 | 5 | 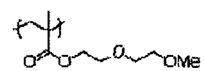 | 52 | 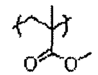 | 43 | 61,000 |

(continued)

| Polymer number | Central nucleus | | Polymer chain | | | | | | Mw |
|---|---|---|---|---|---|---|---|---|---|
| | Number | Mol%*1 | Polymerizable group | Mol% | Hydrophilic group | Mol% | Others | Mol% | |
| P-49 | SD-3 | 0.8 | 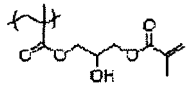 | 5 | 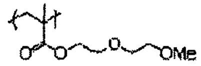 | 52 | 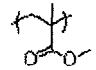 | 43 | 61,000 |
| P-50 | SD-4 | 0.8 | 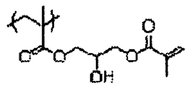 | 5 | 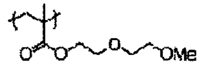 | 52 | 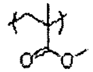 | 43 | 61,000 |
| P-51 | SD-5 | 0.8 | 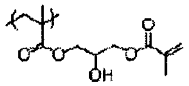 | 5 | 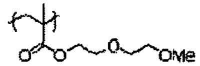 | 52 | 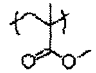 | 43 | 62,000 |
| 1: Ratio (%) of number of moles of SH group to number of total moles of monomer | | | | | | | | | |

[Table 5]

| Polymer number | Central nucleus | | Polymer chain | | | | | | Mw |
|---|---|---|---|---|---|---|---|---|---|
| | Number | Mol%*1 | Polymerizable group | Mol% | Hydrophilic group | Mol% | Others | Mol% | |
| P-52 | SD-8 | 1 | 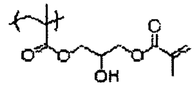 | 5 | 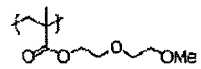 | 52 | 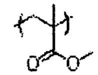 | 43 | 63,000 |
| P-53 | SD-14 | 1 | 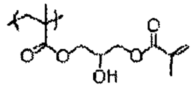 | 5 | 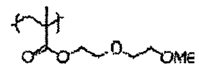 | 52 | 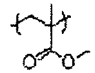 | 43 | 63,000 |
| P-54 | SA-1 | 1 | 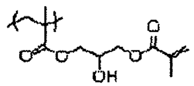 | 5 | 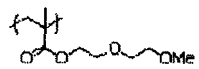 | 52 | 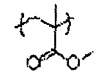 | 43 | 66,000 |
| P-55 | SA-2 | 0.6 | 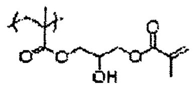 | 5 | 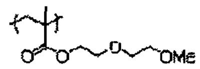 | 52 | 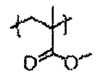 | 43 | 61,000 |
| P-56 | SA-3 | 1 | 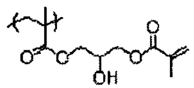 | 5 | 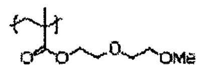 | 52 | 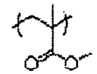 | 43 | 58,000 |
| P-57 | SE-2 | 1 | 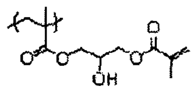 | 5 | 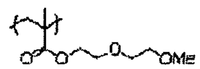 | 52 | 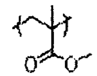 | 43 | 61,000 |
| P-58 | SE-3 | 1 | 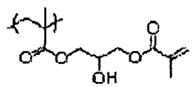 | 5 | 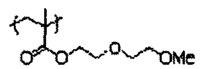 | 82 | 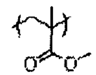 | 43 | 60,000 |
| P-59 | SE-5 | 1 | 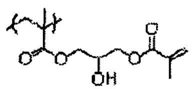 | 5 | 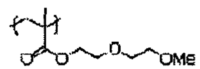 | 52 | 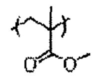 | 43 | 60,000 |
| P-60 | SE-6 | 1 | 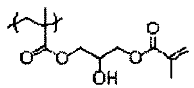 | 5 | 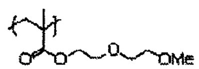 | 52 | 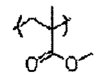 | 43 | 61,000 |

(continued)

| Polymer number | Central nucleus | | Polymer chain | | | | | | Mw |
|---|---|---|---|---|---|---|---|---|---|
| | Number | Mol%*1 | Polymerizable group | Mol% | Hydrophilic group | Mol% | Others | Mol% | |
| P-61 | SE-7 | 1 | 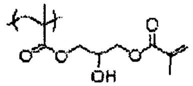 | 5 | 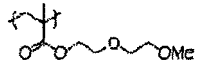 | 52 | 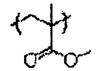 | 43 | 62,000 |
| P-62 | SE-9 | 1 | 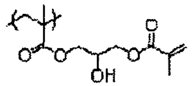 | 5 | 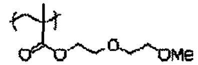 | 52 | 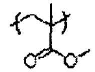 | 43 | 62,000 |
| P-63 | SF-1 | 1 | 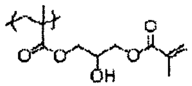 | 5 | 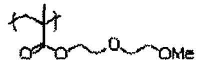 | 52 | 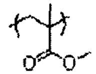 | 43 | 61,000 |

*1: Ratio (%) of number of moles of SH group to number of total moles of monomer

The star-shaped polymer compound can be synthesized through a well-known method such as radical polymerization of the monomer constituting a polymer chain in the presence of the above-described polyfunctional thiol compound.
The mass average molar mass (Mw) of the star-shaped polymer compound is preferably 5,000 to 500,000, more preferably 10,000 to 250,000, and particularly preferably 20,000 to 150,000. In this range, on-press developability and printing durability become more favorable.
The star-shaped polymer compound may be used singly, or two or more types thereof may be used in combination. In addition, a usual straight-chain binder polymer may be used therewith in combination.
The content rate of the star-shaped polymer compound is preferably 5 mass% to 95 mass%, more preferably 10 mass% to 90 mass%, and particularly preferably 15 mass% to 85 mass% with respect to the total solid content of the image recording layer.
The star-shaped polymer compound disclosed in JP2012-148555A is particularly preferable in that permeability of dampening water is promoted and on-press developability is improved.

<Other Components>

It is possible to make the image recording layer A contain other components described below as necessary.

(1) Low Molecular Hydrophilic Compound

The image recording layer may contain a low molecular hydrophilic compound in order to improve on-press developability without decreasing printing durability.
Examples of a water-soluble organic compound of the low molecular hydrophilic compound include glycols such as ethylene glycol, diethylene glycol, triethylene glycol, propylene glycol, dipropylene glycol, and tripropylene glycol, ethers thereof, or ester derivatives thereof, polyols such as glycerol, pentaerythritol, and tris(2-hydroxyethyl)isocyanurate, organic amines such as triethanolamine, diethanolamine, and monoethanolamine, and salts thereof, organic sulfonic acids such as an alkylsulfonic acid, a toluenesulfonic acid, and a benzenesulfonic acid, and salts thereof, an organic sulfamic acid such as an alkyl sulfamic acid, and salts thereof, organic sulfuric acids such as alkyl sulfates and alkyl ether sulfate, and salts thereof, an organic phosphonic acid such as a phenylphosphonic acid, and salts thereof, an organic carboxylic acid such as a tartaric acid, an oxalic acid, a citric acid, a malic acid, a lactic acid, a gluconic acid, and an amino acid, and salts thereof, and betaines.
Among these, the image recording layer preferably contains at least one selected from the group consisting of polyols, organic sulfates, organic sulfonates and betaines.
Examples of specific compounds of organic sulfonate include compounds disclosed in paragraphs [0026] to [0031] of JP2007-276454A and paragraphs [0020] to [0047] of JP2009-154525A. These salts may be potassium salts or lithium salts.
Examples of the organic sulfate include compounds disclosed in paragraphs [0034] to [0038] of JP2007-276454A.
As betaines, a compound in which a hydrocarbon substituent to a nitrogen atom has 1 to 5 carbon atoms is preferable, and specific examples thereof include trimethylammonium acetate, dimethyl propyl ammonium acetate, 3-hydroxy-4-trimethylammonio butyrate, 4-(1-pyridinio)butyrate, 1-hydroxyethyl-1-imidazolio acetate, trimethylammonium methanesulfonate, dimethyl propyl ammonium methanesulfonate, 3-trimethyl ammonio-1-propane sulfonate, and 3-(1-pyridinio)-1-propane sulfonate.
The low molecular hydrophilic compound has a small structure of a hydrophobic portion, and thus, there is almost no surfactant action. Therefore, dampening water does not permeate an exposed portion (image portion) of the image recording layer to decrease hydrophobicity of the image portion and coating strength, and ink receptivity of the image recording layer and printing durability can be favorably maintained.
The addition amount of the low molecular hydrophilic compound is preferably 0.5 mass% to 20 mass%, more preferably 1 mass% to 15 mass%, and still more preferably 2 mass% to 10 mass% of the total solid content amount of the image recording layer. In this range, favorable on-press developability and printing durability can be obtained.
The compounds may be used singly, or two or more types thereof may be used in combination.

(2) Sensitizing Agent

In order to enhance depositing properties, sensitizing agents such as a phosphonium compound, a nitrogen-containing low molecular compound, and an ammonium group-containing polymer are preferably used in the image recording layer. Particularly, in a case where an inorganic layer-shaped compound is contained in a protective layer, these compounds function as a surface coating agent of the inorganic layer-shaped compound, and have an action of

preventing a decrease in depositing properties in the middle of printing due to the inorganic layer-shaped compound.

Preferred examples of the phosphonium compound include phosphonium compounds disclosed in JP2006-297907A and JP2007-50660A. Specific examples thereof include tetrabutylphosphonium iodide, butyl triphenyl phosphonium bromide, tetraphenyl phosphonium bromide, 1,4-bis(triphenylphosphonio)butane=di(hexafluorophosphate), 1,7-bis(triphenylphosphonio)heptane=sulfate, and 1,9-bis(triphenylphosphonio)nonane=naphthalene-2,7-disulfonate.

Examples of the nitrogen-containing low molecular compound include compounds disclosed in paragraphs [0021] to [0037] in JP2008-284858A and paragraphs [0030] to [0057] in JP2009-90645A.

Any ammonium group-containing polymer may be used, as long as the ammonium group-containing polymer has an ammonium group in a structure thereof, but a polymer containing 5 mol% to 80 mol% of (meth)acrylate having an ammonium group in a side chain as a copolymerization component is preferable. Specific examples thereof include polymers disclosed paragraphs [0089] to [0105] of JP2009-208458A.

The value of a reduced specific viscosity (unit: ml/g) of the ammonium group-containing polymer which is obtained through the following measurement method is preferably within a range of 5 to 120, more preferably within a range of 10 to 110, and particularly preferably within a range of 15 to 100. When the above-described reduced specific viscosity is converted into the mass average molecular weight (Mw), 10,000 to 150,000 is preferable, 17,000 to 140,000 is more preferable, and 20,000 to 130,000 is particularly preferable.

<Method for Measuring Reduced Specific Viscosity>

3.33 g (1 g as a solid content) of a 30 mass% polymer solution is weighed into a 20 ml volumetric flask and is diluted with N-methyl pyrrolidone. This solution is allowed to stand for 30 minutes in a thermostatic tube at 30°C and is placed in a Ubbelohde reduction viscosity tube (viscometer constant = 0.010 cSt/s), and the running down time is measured at 30°C. The measurement is performed on an identical sample twice, and an average value thereof is calculated. Measurement is also similarly performed in a case of a blank (only N-methyl pyrrolidone) to calculate the reduced specific viscosity (ml/g) from the following Formula.

$$\text{Reduced specific viscosity (ml/g)} = \frac{\dfrac{\text{Outflow time (seconds) of sample solution} - \text{outflow time (seconds) of blank}}{\text{Outflow time (seconds) of blank}}}{\dfrac{3.33\ (\text{g}) \times \frac{30}{100}}{20\ (\text{ml})}}$$

Specific examples of the ammonium group-containing polymer will be shown below.

(1) 2-(trimethylammonio)ethyl methacrylate=p-toluenesulfonate/3,6-dioxaheptyl methacrylate copolymer (molar ratio of 10/90 and Mw of 45,000); (2) 2-(trimethylammonio)ethyl methacrylate=hexafluorophosphate/3,6-dioxaheptyl methacrylate copolymer (molar ratio of 20/80 and Mw of 60,000); (3) 2-(ethyldimethylammonio)ethyl methacrylate=p-toluenesulfonate/hexyl methacrylate copolymer (molar ratio of 30/70 and Mw of 45,000); (4) 2-(trimethylammonio)ethyl methacrylate=hexafluorophosphate/2-ethylhexyl methacrylate copolymer (molar ratio of 20/80 and Mw of 60,000); (5) 2-(trimethylammonio)ethyl methacrylate=methyl sulfate/hexyl methacrylate copolymer (molar ratio of 40/60 and Mw of 70,000); (6) 2-(butyldimethylammonio)ethyl methacrylate=hexafluorophosphate/3,6-dioxaheptyl methacrylate copolymer (molar ratio of 25/75 and Mw of 65,000); (7) 2-(butyldimethylammonio)ethyl acrylate=hexafluorophosphate/3,6-dioxaheptyl methacrylate copolymer (molar ratio of 20/80 and Mw of 65,000); (8) 2-(butyldimethylammonio)ethyl methacrylate=13-ethyl-5,8,11-trioxa-1-heptadecane sulfonate/3,6-dioxaheptyl methacrylate copolymer (molar ratio of 20/80 and Mw of 75,000); and (9) 2-(butyldimethylammonio)ethyl methacrylate=hexafluorophosphate/3,6-dioxaheptyl methacrylate/2-hydroxy-3-methacryloyloxy propyl methacrylate copolymer (molar ratio of 15/80/5 and Mw of 65,000)

The content of the sensitizing agent is preferably 0.01 mass% to 30.0 mass%, more preferably 0.1 mass% to 15.0 mass%, and still more preferably 1 mass% to 10 mass% with respect to the total solid content of the image recording layer.

(3) Others

As other components, a surfactant, a colorant, a printing agent, a polymerization inhibitor, a higher fatty acid derivative, a plasticizer, inorganic fine particles, an inorganic layer-shaped compound, a co-sensitizer, a chain transfer agent, or the like can be further contained in the image recording layer. Specifically, compounds and addition amounts

disclosed in paragraphs [0114] to [0159] of JP2008-284817A, paragraphs [0023] to [0027] of JP2006-091479A, and paragraph [0060] of US2008/0311520A can be preferably used.

<Formation of Image Recording Layer A>

The image recording layer is formed by preparing a coating liquid after dispersing or dissolving each of the above-described necessary components in a well-known solvent, coating the top of a support with this coating liquid through a well-known method such as bar coater coating, and performing drying, as disclosed in paragraphs [0142] and [0143] of JP2008-195018A. The coating amount (solid content) of the image recording layer on the support obtained after drying differs depending on the application, but, in general, is preferably 0.3 $g/m^2$ to 3.0 $g/m^2$. In this range, favorable sensitivity and coating properties of the image recording layer can be obtained.

(Image Recording Layer B)

The image recording layer B contains an infrared absorber, a polymerization initiator, a polymerizable compound, and a particulate shape polymer compound. Hereinafter, the constituent components of the image recording layer B will be described.

Regarding the infrared absorber, the polymerization initiator, and the polymerizable compound in the image recording layer B, the infrared absorber, the polymerization initiator, and the polymerizable compound described in the image recording layer A can be similarly used.

<Particulate Shape Polymer Compound>

The particulate shape polymer compound is preferably selected from hydrophobic thermoplastic polymer fine particles, thermally reactive polymer fine particles, polymer fine particles having a polymerizable group, a microcapsule including a hydrophobic compound, and microgel (cross-linking polymer fine particle). Among these, polymer fine particles having a polymerizable group and microgel are preferable. In a particularly preferable embodiment, the particulate shape polymer compound contains at least one ethylenically unsaturated polymerizable group. An effect of enhancing printing durability of an exposed portion and on-press developability of an unexposed portion can be obtained due to the presence of such a particulate shape polymer compound.

As the hydrophobic thermoplastic polymer fine particle, hydrophobic thermoplastic polymer fine particles disclosed in Research Disclosure No. 33303 of January 1992, JP1997-123387A (JP-H9-123387A), JP1997-131850A (JP-H9-131850A), JP1997-171249A (JP-H9-171249A), JP1997-171250A (JP-H9-171250A), EP931,647B, and the like are preferable.

Specific examples of the polymer constituting the hydrophobic thermoplastic polymer fine particles include a homopolymer or a copolymer of a monomer such as ethylene, styrene, vinyl chloride, methyl acrylate, ethyl acrylate, methyl methacrylate, ethyl methacrylate, vinylidene chloride, acrylonitrile, vinyl carbazole, acrylate having a polyalkylene structure, or methacrylate, or a mixture thereof. Preferred examples thereof include polystyrene, a copolymer containing styrene and acrylonitrile, and polymethyl methacrylate. The average particle diameter of the hydrophobic thermoplastic polymer fine particle is preferably 0.01 $\mu$m to 3.0 $\mu$m.

Examples of the thermally reactive polymer fine particles include polymer fine particles having a thermally reactive group. The thermally reactive polymer fine particles form a hydrophobic region through cross-linking due to a thermal reaction and through the change in functional groups during the cross-linking.

As the thermally reactive group in the polymer fine particle having a thermally reactive group, a functional group performing any reaction may be used as long as a chemical bond is formed. However, a polymerizable group is preferable, and preferred examples thereof include an ethylenically unsaturated group that performs a radical polymerization reaction (for example, an acryloyl group, a methacryloyl group, a vinyl group, and an allyl group), a cationic polymerizable group (for example, a vinyl group, a vinyloxy group, an epoxy group, and an oxetanyl group), an isocyanate group that performs an addition reaction or a block body thereof, an epoxy group, a vinyloxy group, and a functional group having an active hydrogen atom which is a reaction counterpart thereof (for example, an amino group, a hydroxy group, and a carboxy group), a carboxy group that performs a condensation reaction, a hydroxy group or an amino group which is a reaction counterpart, an acid anhydride that performs a ring-opening addition reaction, and an amino group or a hydroxy group which is a reaction counterpart.

Examples of the microcapsule include a microcapsule containing at least a portion of constituent components of the image recording layer as disclosed in JP2001-277740A and JP2001-277742A. The constituent components of the image recording layer can be contained in a portion other than the microcapsule. A preferred aspect of the image recording layer containing the microcapsule is a configuration of containing a hydrophobic constituent component in the microcapsule and containing a hydrophilic constituent component in a portion other than the microcapsule.

It is possible to make microgel (cross-linking polymer fine particle) contain a portion of the constituent components of the image recording layer in at least one of the surface or the inside of the microgel. Reactive microgel having a radical polymerizable group on the surface thereof is particularly preferable from the viewpoint of image formation sensitivity or printing durability.

As a method for microcapsulating or microgelling the constituent components of the image recording layer, well-known methods can be applied.

The average particle diameter of the particulate shape polymer compound is preferably 0.01 μm to 3.0 μm, more preferably 0.03 μm to 2.0 μm, and still more preferably 0.10 μm to 1.0 μm. In this range, favorable resolution and temporal stability can be obtained.

The content of the particulate shape polymer compound is preferably 5 mass% to 90 mass% with respect to the total solid content of the image recording layer.

<Other Components>

It is possible to make the image recording layer B contain other components described in the image recording layer A as necessary.

<Formation of Image Recording Layer B>

It is possible to apply the description of the formation of the image recording layer A to formation of the image recording layer B.

(Image Recording Layer C)

The image recording layer C contains an infrared absorber and a thermoplastic fine particle polymer. Hereinafter, the constituent components of the image recording layer C will be described.

<Infrared Absorber>

The infrared absorber contained in the image recording layer C is preferably a dye or a pigment having a maximum absorption at 760 nm to 1,200 nm and more preferably a dye having a maximum absorption at 760 nm to 1,200 nm.

As the dye, it is possible to use a commercially available dye and well-known dyes disclosed in literature (for example, "Dye Handbook" which is edited by The Society of Synthetic Organic Chemistry, Japan, and is published in 1970 (S45), "Near Infrared Absorption Coloring Matters" on pp. 45 to 51 of "Chemical Industry" which is published in May 1986, and "Development and Market Trends of Functional Dyes in the 1990s" in Chapter 2, Section 2.3 (CMC Publishing Co., Ltd. published in 1990)), or in patents. Specifically, infrared absorber dyes such as azo dyes, metal complex salt azo dyes, pyrazolone azo dyes, anthraquinone dyes, phthalocyanine dyes, carbonium dyes, quinone imine dyes, polymethine dyes, and cyanine dyes are preferable.

Among these, dyes which are particularly preferable to be added to the image recording layer are infrared absorber dyes having a water-soluble group.

Specific examples of the infrared absorber dyes will be shown below, but the present invention is not limited thereto.

(IR-1)

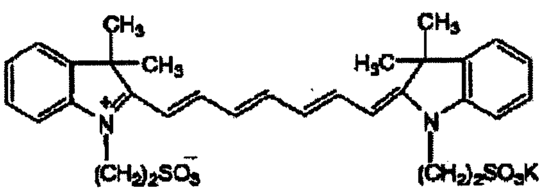

(IR-2)

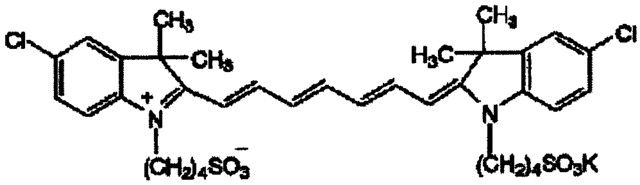

(IR-3)

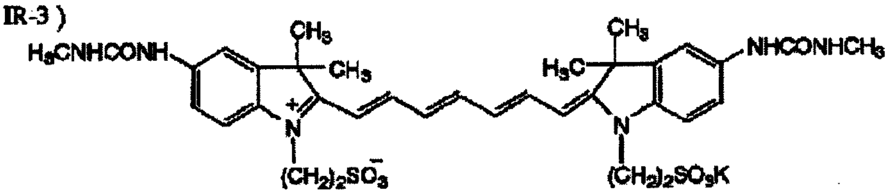

(IR-4)

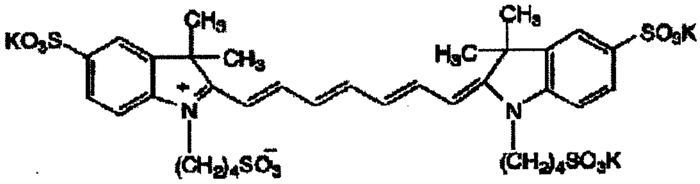

(IR-5)

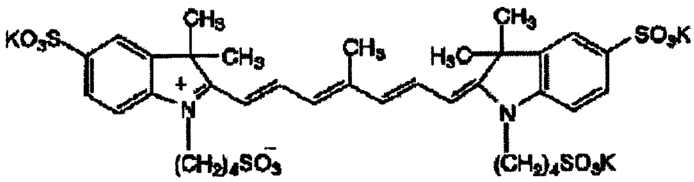

(IR-6)

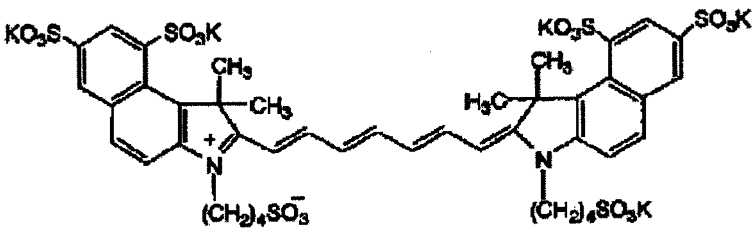

(IR-7)

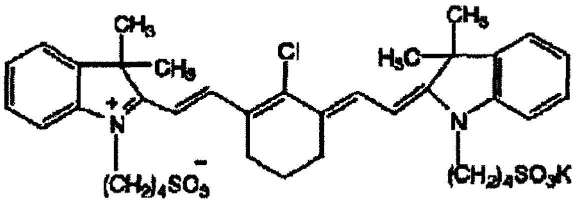

(IR-8)

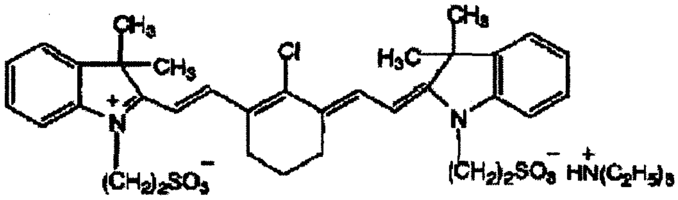

(IR-9)

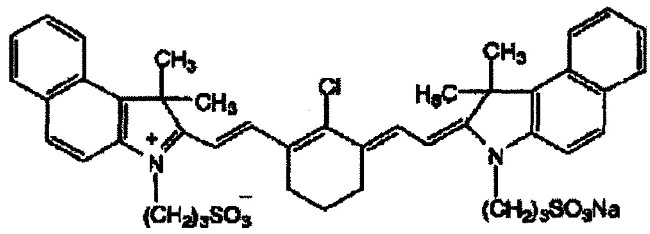

(IR-10)

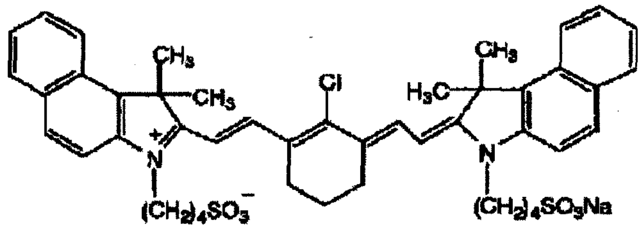

(IR-11)

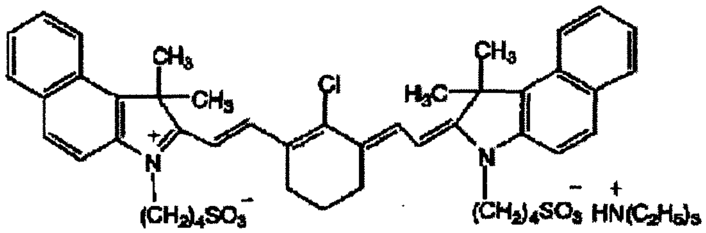

As the pigments, it is possible to use commercially available pigments and pigments disclosed in color index (C.I.) handbook, "Latest Pigment Handbook" (edited by The Japan Society of Colour Material, published in 1977), "Latest Pigment Application Technology" (CMC Publishing Co., Ltd. published in 1986), and "Printing Ink Technology" (CMC Publishing Co., Ltd, published in 1984).

The particle diameter of a pigment is preferably 0.01 μm to 1 μm and more preferably 0.01 μm to 0.5 μm. Well-known dispersion technology used for ink manufacture, toner manufacture, and the like can be used as a method for dispersing pigments. The details of the technology are disclosed in "Latest Pigment Application Technology" (CMC Publishing Co., Ltd. published in 1986).

The amount of the infrared absorber is preferably 0.1 mass% to 30 mass%, more preferably 0.25 mass% to 25 mass%, and particularly preferably 0.5 mass% mass to 20 mass% with respect to the solid content of the image recording layer. In this range, favorable sensitivity can be obtained without impairing the film strength of the image recording layer.

<Thermoplastic Fine Particle Polymer>

The glass transition temperature (Tg) of the thermoplastic fine particle polymer is preferably 60°C to 250°C. Tg of the thermoplastic fine particle polymer is more preferably 70°C to 140°C and still more preferably 80°C to 120°C.

Suitable examples of the thermoplastic fine particle polymer having Tg of greater than or equal to 60°C include thermoplastic fine particle polymers disclosed in Reseach Disclosure No. 33303 of January 1992, JP1997-123387A(JP-H9-123387A), JP1997-131850A (JP-H9-131850A), JP1997-171249A (JP-H9-171249A), JP1997-171250A (JP-H9-171250A), EP931,647B, and the like.

Specific examples thereof include a homopolymer or a copolymer constituted of a monomer, such as ethylene, styrene, vinyl chloride, methyl acrylate, ethyl acrylate, methyl methacrylate, ethyl methacrylate, vinylidene chloride, acrylonitrile, or vinyl carbazole, or a mixture thereof. Preferred examples thereof include polystyrene, and polymethyl methacrylate.

The average particle diameter of the thermoplastic fine particle polymer is preferably 0.005 μm to 2.0 μm. If the average particle diameter is too large, in some cases, the resolution is deteriorated, and if the average particle diameter is too small, in some cases, the temporal stability is deteriorated. This value can also be applied to the average particle diameter in a case where two or more types of thermoplastic fine particle polymers are mixed with each other.

The average particle diameter thereof is more preferably 0.01 μm to 1.5 μm and particularly preferably 0.05 μm to 1.0 μm. The polydispersity in a case where two or more types of thermoplastic fine particle polymers are mixed with each other is preferably greater than or equal to 0.2. The average particle diameter and the polydispersity are calculated through laser beam scattering.

Two or more types of thermoplastic fine particle polymers may be mixed with each other. Specific examples thereof include use of at least two types thereof which differ in particle size or use of at least two types thereof which differ in Tg. The coating curability of an image portion is more improved by mixing two or more types of thermoplastic fine particle polymers, and the printing durability is more improved in a case where the plate is set to a lithographic printing plate.

For example, in a case of using thermoplastic fine particle polymers having the same sizes as each other, there is a certain gap between the thermoplastic fine particle polymers. Accordingly, in some cases, the level of the coating curability is not desirable even if the thermoplastic fine particle polymers are melted and solidified through image exposure. In contrast, in a case of using thermoplastic fine particle polymers having different sizes from each other, it is possible to reduce the porosity between the thermoplastic fine particle polymers. As a result, it is possible to improve the coating curability of an image portion after image exposure.

In addition, in a case of using thermoplastic fine particle polymers having the same Tg as each other, when the temperature of the image recording layer is not sufficiently increased through image exposure, in some cases, the thermoplastic fine particle polymers are not sufficiently melted and solidified, and therefore, the level of the coating curability is not desirable. In contrast, in a case of using thermoplastic fine particle polymers which differ in Tg, even when the temperature of the image recording layer is not sufficiently increased through image exposure, it is possible to improve the coating curability of an image portion.

In a case of using two or more types of the thermoplastic fine particle polymers which differ in Tg in combination, Tg of at least one thermoplastic fine particle polymer is preferably greater than or equal to 60°C. At this time, the difference in Tg is preferably greater than or equal to 10°C and more preferably greater than or equal to 20°C. In addition, greater than or equal to 70 mass% of the thermoplastic fine particle polymer of which Tg is greater than or equal to 60°C is preferably contained with respect to the total thermoplastic fine particle polymers.

The thermoplastic fine particle polymer may have a crosslinkable group. By using the thermoplastic fine particle polymer having a crosslinkable group, a crosslink is formed between polymers through a thermal reaction of the crosslinkable group due to heat generated in an image exposure portion, and therefore, the coating strength of an image portion is enhanced and the printing durability becomes more excellent. As the crosslinkable group, a functional group which performs any reaction may be used as long as a chemical bond is formed. Examples thereof include an ethylenically unsaturated group (for example, an acryloyl group, a methacryloyl group, a vinyl group, and an allyl group) which performs a polymerization reaction, an isocyanate group which performs an addition reaction or a block body thereof, and a group (for example, an amino group, a hydroxy group, and a carboxyl group) having an active hydrogen atom which is a reaction counterpart thereof, an epoxy group which similarly performs an addition reaction, and an amino group, a carboxyl group, or a hydroxy group which is a reaction counterpart thereof, a carboxyl group that performs a condensation reaction, and a hydroxy group or an amino group, an acid anhydride which performs a ring-opening addition reaction, and an amino group or a hydroxy group which is a reaction counterpart.

Specific examples of the thermoplastic fine particle polymer having a crosslinkable group include a thermoplastic fine particle polymer having a crosslinkable group such as an acryloyl group, a methacryloyl group, a vinyl group, an allyl group, an epoxy group, an amino group, a hydroxy group, a carboxy group, an isocyanate group, anhydride, and a group protecting these groups. Introduction of these crosslinkable groups into a polymer may be performed during polymerization of a fine particle polymer, or may be performed through a polymer reaction after polymerization of a fine particle polymer.

In a case of introducing a crosslinkable group into a polymer during polymerization of a fine particle polymer, emulsion polymerization or suspension polymerization of a monomer having a crosslinkable group is preferable. Specific examples of the monomer having a crosslinkable group include allyl methacrylate, allyl acrylate, vinyl methacrylate, vinyl acrylate, glycidyl methacrylate, glycidyl acrylate, 2-isocyanate ethyl methacrylate or a blocked isocyanate which is blocked by alcohol thereof, 2-isocyanate ethyl acrylate or a blocked isocyanate which is blocked by alcohol thereof, 2-aminoethyl methacrylate, 2-aminoethyl acrylate, 2-hydroxyethyl methacrylate, 2-hydroxyethyl acrylate, an acrylic acid, a methacrylic acid, maleic anhydride, bifunctional acrylate, and bifunctional methacrylate.

Examples of a polymer reaction which is used in a case of performing introduction of a crosslinkable group after polymerization of a fine particle polymer include a polymer reaction disclosed in WO96/34316A.

Thermoplastic fine particle polymers may be reacted with each other through a crosslinkable group, or a thermoplastic fine particle polymer may be reacted with a polymer compound or a low molecular compound which is added to the image recording layer.

The content of the thermoplastic fine particle polymer is preferably 50 mass% to 95 mass% of the solid content of the image recording layer, more preferably 60 mass% to 90 mass% of the solid content of the image recording layer,

and particularly preferably 70 mass% to 85 mass% of the solid content of the image recording layer.

<Other components>

It is possible to make the image recording layer C further contain other components as necessary.

<Surfactant Having Polyoxyalkylene Group or Hydroxy Group>

As a surfactant having a polyoxyalkylene group (hereinafter, also described as a POA group) or a hydroxy group, a surfactant having a POA group or a hydroxy group can be appropriately used, but an anionic surfactant or a nonionic surfactant is preferable. In the anionic surfactant or the nonionic surfactant having a POA group or a hydroxy group, an anionic surfactant or a nonionic surfactant having a POA group is preferable.

As the POA group, a polyoxyethylene group, polyoxypropylene group, polyoxybutylene group, and the like are preferable and a polyoxyethylene group is particularly preferable.

In general, the average polymerization degree of an oxyalkylene group is appropriately 2 to 50 and preferably 2 to 20.

In general, the number of hydroxy groups is appropriately 1 to 10 and preferably 2 to 8. However, a terminal hydroxy group in the oxyalkylene group is not included in the number of hydroxy groups.

(POA Group or Anionic Surfactant Having Hydroxy Group)

The anionic surfactant having a POA group is not particularly limited, and examples thereof include polyoxyalkylene alkyl ether carboxylates, polyoxyalkylene alkyl sulfosuccinates, polyoxyalkylene alkyl ether sulfate ester salts, alkylphenoxypolyoxyalkylene propyl sulfonic acid salts, polyoxyalkylene alkyl sulfophenyl ethers, polyoxyalkylene aryl ether sulfate ester salts, polyoxyalkylene polycyclic phenyl ether sulfate ester salts, polyoxyalkylene styryl phenyl ether sulfate ester salts, polyoxyalkylene alkyl ether phosphoric acid ester salts, polyoxyalkylene alkyl phenyl ether phosphoric acid ester salts, and polyoxyalkylene perfluoroalkyl ether phosphoric acid ester salts.

The anionic surfactant having a hydroxy group is not particularly limited, and examples thereof include hydroxy carboxylates, hydroxy alkyl ether carboxylates, hydroxy alkan sulfonic acid salts, fatty acid monoglyceride sulfate ester salts, and fatty acid monoglyceride phosphoric acid ester salts.

The content of a surfactant having a POA group or a hydroxy group is preferably 0.05 mass% to 15 mass% of the solid content of the image recording layer and more preferably 0.1 mass% to 10 mass% of the solid content of the image recording layer.

Hereinafter, specific examples of the surfactant having a POA group or a hydroxy group will be shown below, but the present invention is not limited thereto. The following surfactant A-12 can be obtained from Du Pont Kabushiki Kaisha with a product name of ZONYL FSP. In addition, the following surfactant N-11 can be obtained from Du Pont Kabushiki Kaisha with a product name of ZONYL FSO 100.

A-1 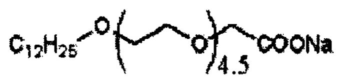

A-2 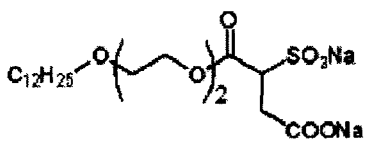

A-3 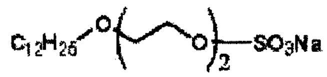

A-9 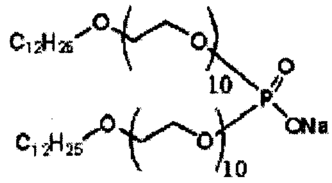

A-10 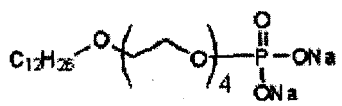

A-4
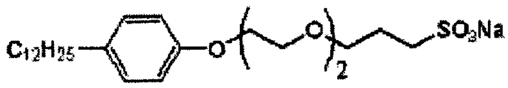

A-5
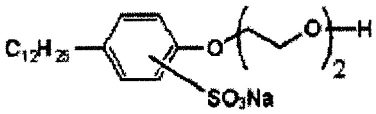

A-6
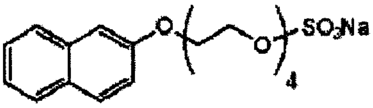

A-7
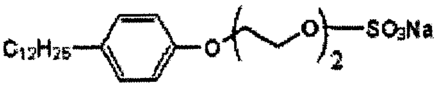

A-8
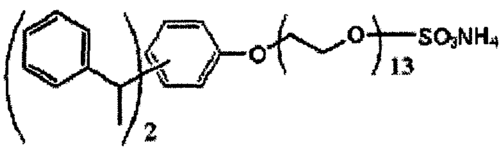

A-11
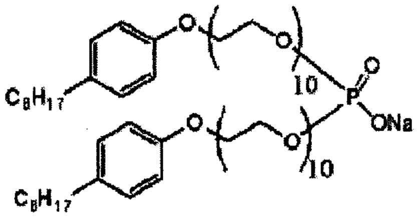

A-12
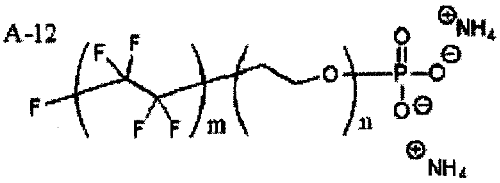

A-13
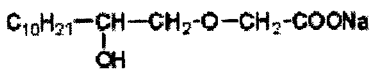

A-14
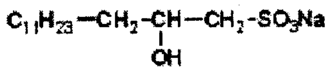

A-15
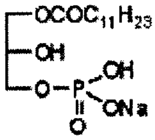

N-1 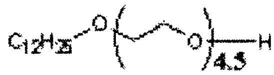

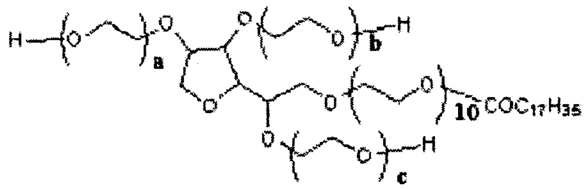

a+b+c=20

N-8

N-2 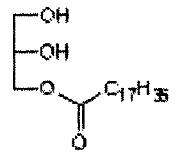

N-3 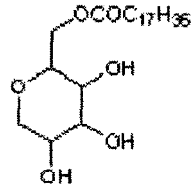

N-9 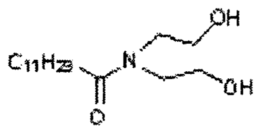

N-4 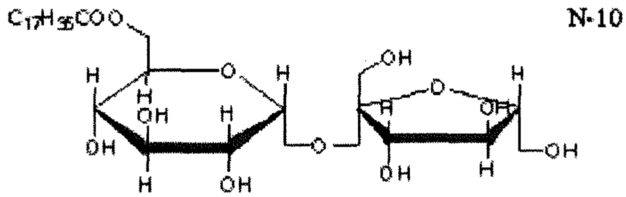

N-10 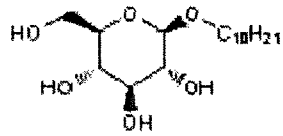

N-5 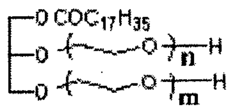 m+n=5

N-11 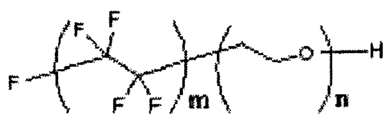

N-6 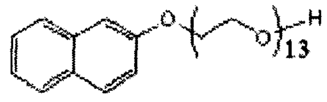

N-7 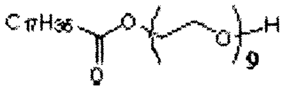

The image recording layer may contain an anionic surfactant having no polyoxyalkylene group and no hydroxy group for the purpose of securing uniformity of coating of the image recording layer.

The anionic surfactant is not particularly limited as long as the above-described purpose is achieved. Among these, an alkyl benzene sulfonic acid or a salt thereof, an alkyl naphthalene sulfonic acid or a salt thereof, a (di)alkyl diphenyl ether (di)sulfonic acid or a salt thereof, and an alkyl sulfate ester salt are preferable.

The content of the anionic surfactant having no polyoxyalkylene group and no hydroxy group is preferably 1 mass% to 50 mass% and more preferably 1 mass% to 30 mass% with respect to the surfactant having a polyoxyalkylene group and a hydroxy group.

Specific examples of the anionic surfactant having no polyoxyalkylene group and no hydroxy group will be shown below, but the present invention is not limited thereto.

AA-1 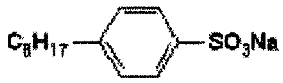

AA-2 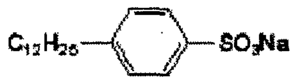

AA-3 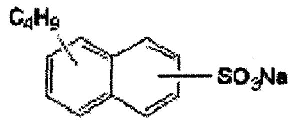

AA-4 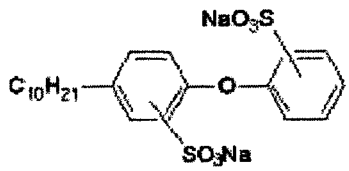

AA-5 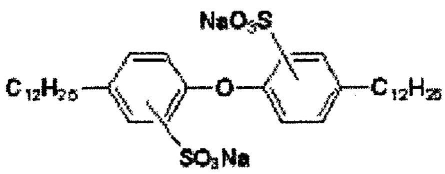

AA-6 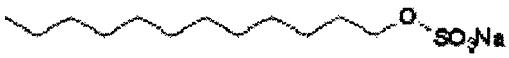

The image recording layer may contain a fluorine-based surfactant, or a nonionic surfactant having no polyoxyalkylene group and no hydroxy group for the purpose of securing uniformity of coating of the image recording layer. For example, fluorine-based surfactants disclosed in JP1987-170950A (JP-S62-170950A) are preferably used.

It is possible to make the image recording layer contain a hydrophilic resin. As the hydrophilic resin, a resin having a hydrophilic group such as a hydroxy group, a hydroxy ethyl group, a hydroxy propyl group, an amino group, an amino ethyl group, an amino propyl group, a carboxyl group, a carboxylato group, a sulfo group, a sulfonate group, or a phosphoric acid group is preferable.

Specific examples of the hydrophilic resin include gum arabic, casein, gelatin, starch derivatives, carboxymethyl cellulose and a sodium salt thereof, cellulose acetate, sodium alginate, vinyl acetate-maleic acid copolymers, styrene-maleic acid copolymers, a polyacrylic acid, and salts thereof, polymethacrylic acids and salts thereof, a homopolymer and a copolymer of hydroxy ethyl methacrylate, a homopolymer and a copolymer of hydroxy ethyl acrylate, a homopolymer and a copolymer of hydroxy propyl methacrylate, a homopolymer and a copolymer of hydroxy propyl acrylate, a homopolymer and a copolymer of hydroxy butyl methacrylate, a homopolymer and a copolymer of hydroxy butyl acrylate, polyethylene glycols, hydroxy propylene polymers, polyvinyl alcohols, a homopolymer and a copolymer of hydrolyzed polyvinyl acetate, polyvinyl formal, polyvinyl butyral, polyvinyl pyrrolidone, or acrylamide of which the hydrolysis is at least 60% and is preferably at least 80%, a homopolymer and a copolymer of methacrylate, and a homopolymer and a copolymer of N-methylol acrylamide.

The molecular weight of the hydrophilic resin is preferably greater than or equal to 2,000. If the molecular weight thereof is less than 2,000, it is impossible to obtain sufficient coating strength or printing durability, which is not preferable.

The content of the hydrophilic resin is preferably 0.5 mass% to 50 mass% of the solid content of the image recording layer and more preferably 1 mass% to 30 mass% of the solid content of the image recording layer.

The image recording layer may contain inorganic fine particles. Suitable examples of the inorganic fine particles include silica, alumina, magnesium oxide, titanium oxide, magnesium carbonate, calcium alginate, or mixtures thereof. The inorganic fine particles can be used for the purpose of strengthening a coating or the like.

The average particle diameter of an inorganic fine particle is preferably 5 nm to 10 μm and more preferably 10 nm to 1 μm. In this range, the inorganic fine particles can be stably dispersed with thermoplastic fine particle polymers, the film strength of the image recording layer can be sufficiently maintained, and a non-image portion in which printing

stains are hardly caused and which is excellent in hydrophilicity.

The inorganic fine particles can be easily obtained as commercially available products of colloidal silica dispersion products or the like.

The content of the inorganic fine particles is preferably 1.0 mass% to 70 mass% of the solid content of the image recording layer and more preferably 5.0 mass% to 50 mass% of the solid content of the image recording layer.

It is possible to make the image recording layer contain a plasticizer in order to impart flexibility of a coating film. Examples of the plasticizer include polyethylene glycol, tributyl citrate, diethyl phthalate, dibutyl phthalate, dihexyl phthalate, dioctyl phthalate, tricresyl phosphate, tributyl phosphate, trioctyl phosphate, and tetrahydrofurfuryl oleate.

The content of the plasticizer is preferably 0.1% to 50 mass% of the solid content of the image recording layer and more preferably 1 mass% to 30 mass%.

In a case of using a fine particle polymer having a thermally reactive functional group (crosslinkable group) in the image recording layer, it is possible to add a compound of starting or promoting a reaction of the thermally reactive functional group (crosslinkable group) as necessary. Examples of the compound of starting or promoting a reaction of the thermally reactive functional group include a compound which may generate a radical or a cation through heating. Examples thereof include a lophine dimer, a trihalomethyl compound, peroxide, an azo compound, a diazonium salt, an onium salt containing a diphenyliodonium salt, acyl phosphine, and imido sulfonate. The amount of such a compound added is preferably 1 mass% to 20 mass% of the solid content of the image recording layer and is more preferably 1 mass% to 10 mass% of the solid content of the image recording layer. In this range, a favorable effect of starting or promoting a reaction can be obtained without impairing on-press developability.

<Formation of Image Recording Layer C>

The image recording layer is formed such that the above-described each of the necessary components are dissolved or dispersed in an appropriate solvent to prepare a coating liquid with which a support is coated. As the solvent, water or a mixed solvent of water and an organic solvent can be used. The use of the mixed solvent of water and an organic solvent is preferable in view of making the surface shape after coating favorable. The amount of the organic solvent differs depending on the types of organic solvents cannot be unconditionally specified, but is, in general, preferably 5 volume% to 50 volume% in the mixed solvent. However, it is necessary to use the organic solvent in an amount within a range in which the thermoplastic fine particle polymer is not aggregated. The concentration of the solid content of the coating liquid for an image recording layer is preferably 1 mass% to 50 mass%.

The organic solvent used as a solvent of the coating liquid is preferably an organic solvent which is soluble in water. Specific examples thereof include an alcohol solvent such as methanol, ethanol, propanol, isopropanol, and 1-methoxy-2-propanol, a ketone solvent such as acetone and methyl ethyl ketone, a glycol ether solvent such as ethylene glycol dimethyl ether, γ-butyrolactone, N,N-dimethylformamide, N,N-dimethylacetamide, tetrahydrofuran, and dimethyl sulfoxide. Particularly, an organic solvent of which the boiling point is less than or equal to 120°C and the solubility (dissolved amount with respect to 100 g of water) with respect to water is greater than or equal to 10 g and more preferably a organic solvent of which the solubility thereof is greater than or equal to 20 g.

As the coating method using the coating liquid for an image recording layer, various methods can be used. Examples thereof include bar coater coating, rotary coating, spray coating, curtain coating, dip coating, air knife coating, blade coating, and roll coating. The coating amount (solid content) of the image recording layer on a support obtained after drying differs depending on the application, but in general, is preferably 0.5 $g/m^2$ to 5.0 $g/m^2$ and more preferably 0.5 $g/m^2$ to 2.0 $g/m^2$.

Hereinafter, other components of the lithographic printing plate precursor will be described.

[Undercoat Layer]

In the lithographic printing plate precursor, it is preferable to provide an undercoat layer (in some cases, also called an interlayer) between the image recording layer and the support. The undercoat layer strengthens adhesion between the support and the image recording layer in an exposed portion and makes separation of the image recording layer from the support in the unexposed portion easier, thereby contributing improvement of on-press developability without impairing printing durability. In addition, in a case of infrared laser exposure, the undercoat layer has an action of functioning as a heat insulating layer, and thus preventing heat generated by exposure from diffusing to the support so as to decrease sensitivity.

Specific examples of compounds used in the undercoat layer include silane coupling agents having an ethylenic double bond reactive group that can perform addition polymerization disclosed in JP1998-282679A (JP-H10-282679A), and phosphorous compounds that have an ethylenic double bond reactive group disclosed in JP1990-304441A (JP-H2-304441A). Examples of the preferred compounds include polymer compounds having an adsorption group, which can be adsorbed to the surface of the support, a hydrophilic group, and a crosslinkable group as disclosed in

JP2005-125749A and JP2006-188038A. Such a polymer compound is preferably a copolymer of a monomer having an adsorption group, a monomer having a hydrophilic group, and a monomer having a crosslinkable group. Specific examples thereof include a copolymer of a monomer having an adsorption group such as a phenolic hydroxy group, a carboxy group, $-PO_3H_2$, $-OPO_3H_2$, $-CONHSO_2-$, $-SO_2NHSO_2-$, and $-COCH_2COCH_3$, a monomer having a hydrophilic group such as sulfo group, and a monomer having a polymerizable crosslinkable group such as a methacrylic group and an allyl group. The polymer compound may have a crosslinkable group that is introduced by forming a salt between a polar substituent of the polymer compound and a compound which has a substituent having opposite charges to the polar substituent thereof and an ethylenically unsaturated bond, and may be further copolymerized with a monomer other than the monomers described above, preferably with a hydrophilic monomer.

The content of unsaturated double bonds in a polymer compound for an undercoat layer is preferably 0.1 mmol to 10.0 mmol and more preferably 2.0 mmol to 5.5 mmol per 1 g of the polymer compound.

With respect to the polymer compound for an undercoat layer, a mass average molar mass is preferably greater than or equal to 5000 and more preferably 10,000 to 300,000.

In addition to the above-described compound for an undercoat layer, in order to prevent stains over time, it is possible to make the undercoat layer contain a chelating agent, secondary or tertiary amine, a polymerization inhibitor, an amino group, or a compound or the like having a group that interacts with a functional group having polymerization inhibiting ability and the surface of an aluminum support (for example, 1,4-diazabicyclo[2,2,2]octane (DABCO), 2,3,5,6-tetrahydroxy-p-quinone, chloranil, a sulfophthalic acid, a hydroxyethyl ethylene diamine triacetic acid, a dihydroxyethyl ethylene diamine diacetic acid, and hydroxy ethylimino diacetic acid).

The undercoat layer is coated through a well-known method. The coating amount (solid content) of the undercoat layer is preferably 0.1 $mg/m^2$ to 100 $mg/m^2$ and more preferably 1 $mg/m^2$ to 30 $mg/m^2$.

(Support)

As supports of the lithographic printing plate precursor, well-known supports can be used. Among these, an aluminum sheet which is subjected to roughening processing and anodic oxidation processing through a well-known method is preferable.

If necessary, enlargement processing or sealing processing of micropores of anodic oxidation coating disclosed in JP2001-253181A or JP2001-322365A, and surface hydrophilization processing using alkali metal silicate disclosed in US2,714,066A, US3,181,461A, US3,280,734A, and US3,902,734A, or using a polyvinyl phosphonic acid disclosed in US3,276,868A, US4,153,461A, and US4,689,272A are appropriately selected and performed on the above-described aluminum sheet.

The center line average roughness of the support is preferably 0.10 $\mu m$ to 1.2 $\mu m$.

If necessary, a back coat layer containing an organic polymer compound disclosed in JP1993-45885A (JP-H5-45885A) and a silicon alkoxy compound disclosed in JP1994-35174A (JP-H6-35174A) can be provided to the rear surface of the support.

(Protective Layer)

In the lithographic printing plate precursor, it is preferable to provide a protective layer (overcoat layer) on the image recording layer. The protective layer has a function of preventing generation of cracks in the image recording layer and preventing ablation at the time of high illuminance laser exposure in addition to a function of suppressing image formation inhibiting reaction through oxygen blockage.

The protective layer having such characteristics is disclosed in, for example, US3,458,311A and JP1980-49729B (JP-S55-49729B). As a polymer with low oxygen permeability used in the protective layer, any of a water-soluble polymer and a water-insoluble polymer can be appropriately selected and used, and two or more types thereof can be used as necessary after being mixed with each other. Specifically, examples thereof include polyvinyl alcohol, modified polyvinyl alcohol, polyvinyl pyrrolidone, a water-soluble cellulose derivative, and poly(meth)acrylonitrile.

As the modified polyvinyl alcohol, acid modified polyvinyl alcohol having a carboxy group or a sulfo group is preferably used. Specifically, preferred examples thereof include modified polyvinyl alcohol disclosed in JP2005-250216A and JP2006-259137A.

In order to improve oxygen barrier properties, the protective layer preferably contains an inorganic layer-shaped compound such as natural mica and synthetic mica as disclosed in JP2005-119273A.

It is preferable to make the protective layer contain polysaccharides. Examples of the polysaccharide include starch derivatives (for example, dextrin, enzymatic degradation dextrin, a hydroxypropylated starch, a carboxymethylated starch, a phosphoric acid-esterified starch, a polyoxyalkylene grafted starch, and a cyclodextrin), celluloses (for example, carboxymethyl cellulose, carboxyethyl cellulose, methyl cellulose, hydroxypropyl cellulose, and methylpropyl cellulose), carrageenan, an alginic acid, guar gum, Locust bean gum, xanthan gum, gum arabic, and soybean polysaccharides.

Among these, starch derivatives such as dextrin and polyoxyalkylene grafted starch, gum arabic, carboxymethyl cellulose, and soybean polysaccharides are preferably used.

The polysaccharides are preferably used within a range of 1 mass% to 20 mass% with respect to the solid content of the protective layer.

Furthermore, it is possible to make the protective layer contain well-known additives such as a plasticizer for providing flexibility, a surfactant for improving coating properties, and inorganic fine particles for controlling sliding properties of the surface. In addition, it is also possible to make a sensitizing agent described in the section of the image recording layer be contained in the protective layer.

The protective layer is coated through a well-known method. The coating amount of the protective layer is preferably 0.01 $g/m^2$ to 10 $g/m^2$, more preferably 0.02 $g/m^2$ to 3 $g/m^2$, and particularly preferably 0.02 $g/m^2$ to 1 $g/m^2$ in terms of the coating amount after drying.

[Shape of End Portion of Lithographic Printing Plate Precursor]

In the lithographic printing plate precursor used in the processing method according to the present invention, the end portion thereof preferably has a shear droop shape. Use of the lithographic printing plate precursor of which the end portion has a shear droop shape is useful for preventing edge stains in combination with the processing method according to the present invention.

Fig. 1 is a view schematically showing a sectional shape of a lithographic printing plate precursor.

In Fig. 1, a lithographic printing plate precursor 1 has a sag 2 at an end portion of the lithographic printing plate precursor. The distance X between an upper end (boundary point between the sag 2 and an end surface 1c) of the end surface 1c of the lithographic printing plate precursor 1 and an extension line of an image recording layer surface 1a (the surface of a protective layer in a case where the protective layer is formed) is called "amount of shear droop", and the distance Y between a point at which the image recording layer surface 1a of the lithographic printing plate precursor 1 starts to be sagged and an extension line of the end surface 1c is called "width of shear droop". The amount of shear droop of the end portion in the lithographic printing plate precursor is greater than or equal to 35 μm. The upper limit of the amount of shear droop is 150 μm, If the amount of shear droop exceeds 150 μm, the state of the surface of the end portion is significantly deteriorated, and therefore, the on-press developability is deteriorated. In a case where the range of the amount of shear droop is 35 μm to 150 μm, if the width of shear droop is small, cracks are generated in the end portion which causes generation of stains due to printing ink accumulated therein. In order to reduce the generation of such cracks, the range of the width of shear droop is within a range of 50 μm to 300 μm and is preferably within a range of 70 μm to 250 μm. The above-described ranges of the amount of shear droop and the width of shear droop are not related to the shape of an edge of a support surface 1b of the lithographic printing plate precursor 1.

In general, in a boundary B between the image recording layer and the support, and the support surface 1b in the end portion of the lithographic printing plate precursor 1, a sag is generated similarly to in the image recording layer surface 1a.

The formation of the end portion having the above-described sag can be performed by, for example, adjusting the conditions of cutting the lithographic printing plate precursor.

Specifically, the formation of the end portion can be performed by adjusting the gap between an upper cutting blade and a lower cutting blade of a slitter device used during cutting the lithographic printing plate precursor, the biting amount, the blade tip angle, and the like.

For example, Fig. 2 is a sectional view showing a cutting unit of a slitter device. In the slitter device, a pair of upper and lower cutting blades 10 and 20 are disposed on right and left sides. These cutting blades 10 and 20 are formed of a disc-shaped round blade. Upper cutting blades 10a and 10b are coaxially supported by a rotary shaft 11 and lower cutting blades 20a and 20b are coaxially supported by a rotary shaft 21. The upper cutting blades 10a and 10b and the lower cutting blades 20a and 20b are rotated in directions opposite to each other. A lithographic printing plate precursor 30 is cut in a predetermined width by being passed through the gap between the upper cutting blades 10a and 10b and the lower cutting blades 20a and 20b. It is possible to form an end portion having a sag by adjusting the gap between the upper cutting blade 10a and the lower cutting blade 20a and the gap between the upper cutting blade 10b and the lower cutting blade 20b of the cutting unit of the slitter device.

When cutting the lithographic printing plate precursor, methods disclosed in JP1996-58257A (JP-H8-58257A), JP1997-211843A (JP-H9-211843A), JP1998-100556A (JP-H10-100556A), and JP1999-52579A (JP-H11-52579A) can be used.

[Image Exposure]

Image exposure of the on-press development-type lithographic printing plate precursor in the processing method according to the present invention can be performed according to a usual operation of image exposure of an on-press

development-type lithographic printing plate precursor.

The image exposure is performed by laser exposure through a transparent original image having a linear image, a halftone dot image, or the like or by laser beam scanning or the like using digital data. A wavelength of a light source of 700 nm to 1400 nm is preferably used. As the light source at 700 nm to 1400 nm, a solid laser and a semiconductor laser which apply an infrared ray are suitable. The output of the infrared laser is preferably greater than or equal to 100 mW, the exposure time per one pixel is preferably within 20 microseconds, and the irradiation energy amount is preferably 10 $mJ/cm^2$ to 300 $mJ/cm^2$. In order to reduce the exposure time, a multibeam laser device is preferably used. An exposure mechanism may be any of an inner drum type, an outer drum type, a flat bed type, and the like. The image exposure can be performed through a conventional method using a plate setter.

[On-Press Development and Printing]

On-press development and printing of a lithographic printing plate precursor in which an end portion region is coated with a processing liquid containing a hydrophilizing agent can be performed through a usual method. That is, if the lithographic printing plate precursor in which the end portion region is coated with a processing liquid containing a hydrophilizing agent is mounted on a plate cylinder (cylinder) to supply dampening water and printing ink to the lithographic printing plate precursor, an image recording layer which has been cured through exposure forms a printing ink reception portion which has a lipophilic surface, in an exposed portion of the image recording layer. In contrast, in an unexposed portion, an uncured image recording layer is removed by being dissolved or dispersed by the supplied dampening water and/or printing ink, and the hydrophilic surface is exposed to the portion. As a result, the dampening water is attached to the exposed hydrophilic surface and the printing ink is deposited on the image recording layer of the exposed region to start printing.

Here, the one first supplied to the surface of the lithographic printing plate precursor may be dampening water or printing ink. However, it is preferable to first supply dampening water in view of promoting on-press developability by making the dampening water permeate. Examples

The present invention will be more specifically described with reference to Examples below, but the present invention is not limited thereto. The molecular amount of a polymer compound is mass average molar mass (Mw) unless otherwise defined, and the proportion of a repeating unit is a molar percentage.

[Examples 1 to 11 and Comparative Examples 1 to 4]

[Production of Lithographic printing plate precursor I]

(1) Production of Support

In order to remove rolling oil on the surface of an aluminum sheet (material: JIS A 1050) having a thickness of 0.3 mm, degreasing processing was performed for 30 seconds at 50°C using 10 mass% of a sodium aluminate aqueous solution, an aluminum surface was grained using three bundle-implanted nylon brushes having a brush diameter of 0.3 mm and a pumice-aqueous suspension liquid (specific gravity: 1.1 $g/cm^3$) having a median diameter of 25 $\mu$m, and the aluminum sheet was then well washed with water. This aluminum sheet was immersed for 9 seconds in 25 mass% of the sodium hydroxide aqueous solution at 45°C, etched, washed with water, further immersed for 20 seconds in 20 mass% of a nitric acid aqueous solution at 60°C, and washed with water. At this point, the etching amount of the grained surface was about 3 $g/m^2$.

Subsequently, electrochemical roughening processing was continuously performed using 60 Hz of the alternating current voltage. The electrolyte at this point was a 1 mass% nitric acid aqueous solution (containing 0.5 mass% of aluminum ion), and the liquid temperature was 50°C. Electrochemical roughening processing was performed with a carbon electrode as an opposite pole using a trapezoidal rectangular wave alternating current having an alternating current power waveform in which the time TP until a current value reached the peak from zero was 0.8 msec and the duty ratio was 1:1. A ferrite was used as an auxiliary anode. The current density was 30 $A/dm^2$ in terms of a peak value of an electric current, and 5% of the electric current flowing from the power source in the auxiliary anode was distributed. The electricity amount in the nitric acid electrolysis was 175 $C/dm^2$ which was the electricity amount when the aluminum sheet was an anode. Thereafter, washing with water through spraying was performed.

Subsequently, electrochemical roughening processing was performed through the same method as that of nitric acid electrolysis using the electrolyte of a 0.5 mass% hydrochloric acid aqueous solution (containing 0.5 mass% of an aluminum ion) at a liquid temperature of 50°C under the condition of 50 $C/dm^2$ of the electricity amount when the aluminum sheet was an anode, and then, washing with water through spraying was performed.

Subsequently, direct current anodic oxidation coating of 2.5 $g/m^2$ was provided in the aluminum sheet using a 15 mass% sulfuric acid aqueous solution (containing 0.5 mass% of an aluminum ion) as the electrolyte, in an electric

current density of 15 A/$dm^2$, and then, the aluminum sheet was washed with water and dried to produce a support (1).

Thereafter, in order to secure hydrophilicity of the non-image portion, silicate processing was performed on the support (1) for 10 seconds at 60°C using a 2.5 mass% aqueous solution of sodium silicate No. 3, and then, washing with water was performed so as to obtain a support (2). The deposition amount of Si was 10 mg/$m^2$. The center line average roughness (Ra) of the support (2) was measured using a needle having a diameter of 2 μm, and was 0.51 μm.

(2) Formation of Undercoat Layer

Next, a support having an undercoat layer was produced by coating the top of the above-described support (2) with a coating liquid (1) for an undercoat layer which has the following composition such that the dry coating amount became 20 mg/$m^2$.

<Coating Liquid (1) for Undercoat Layer>

- Compound (1) for undercoat layer having the following structure 0.18 g
- Hydroxy ethylimino diacetic acid 0.10 g
- Methanol 55.24 g
- Water 6.15 g

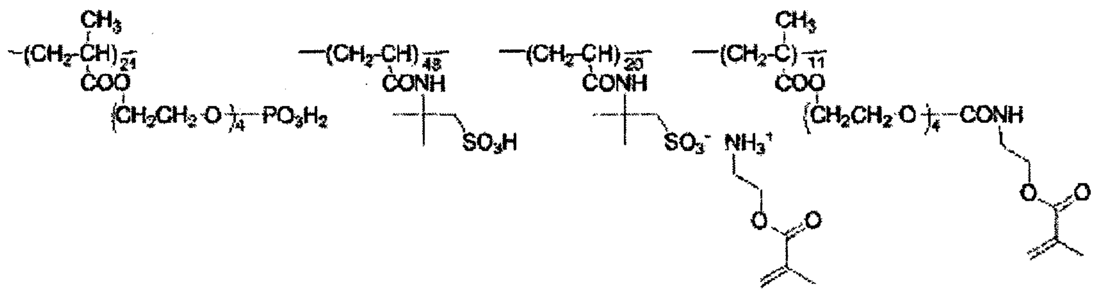

Compound (1) for undercoat layer

Mw: 100,000

(3) Formation of Image Recording Layer

The top of the undercoat layer formed as described above was bar-coated with an image recording layer coating liquid (1) having the following composition, and was then oven-dried for 60 seconds at 100°C to form an image recording layer having a dry coating amount of 1.0 g/$m^2$.

The image recording layer coating liquid (1) was prepared by mixing and stirring a photosensitive liquid (1) and a microgel liquid (1) described below immediately before coating.

<Photosensitive Liquid (1)>

- Polymer compound (binder polymer (1)) [following structure] 0.240 g
- Infrared absorber (1) [following structure] 0.030 g
- Borate compound 0.010 g
  Sodium tetraphenylborate
- Polymerization initiator (1) [following structure] 0.162 g
- Polymerizable compound 0.192 g
  Tris(acryloyloxyethyl)isocyanurate
  (NK ESTER A-9300, manufactured by Shin-Nakamura Chemical Co., Ltd.)
- Anionic surfactant 1 [following structure] 0.050 g
- Sensitizing agent 0.055 g

Phosphonium compound (1) [following structure]
- Sensitizing agent 0.018 g
Benzyl-dimethyl-octylammonium-$PF_6$ salt
- Sensitizing agent 0.040 g
- Ammonium group-containing polymer [following structure]
- Fluorine-based surfactant (1) [following structure] 0.008 g
- 2-Butanone 1.091 g
- 1-Methoxy-2-propanol 8.609 g

<Microgel Liquid (1)>

- Microgel (1) 2.640 g
- Distilled water 2.425 g

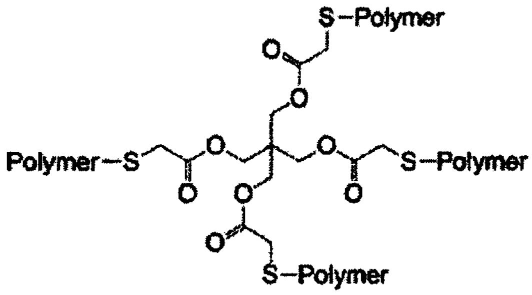

Above-described polymer unit

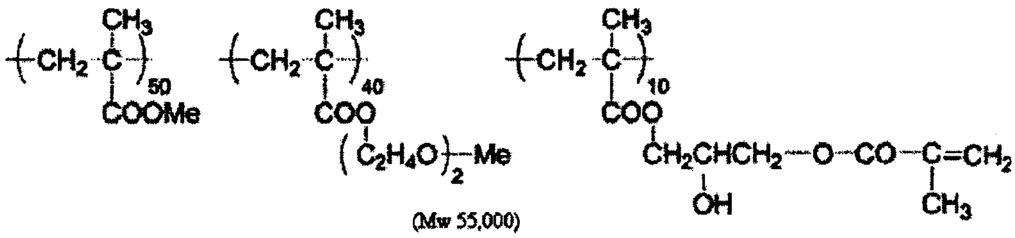

(Mw 55,000)

Binder polymer (1)

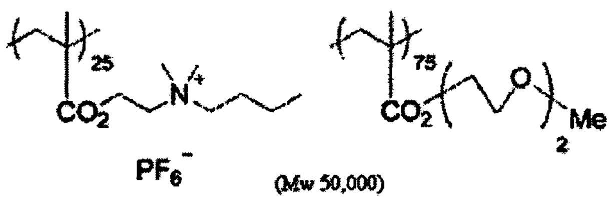

(Mw 50,000)

Ammonium group-containing polymer

Anionic surfactant 1

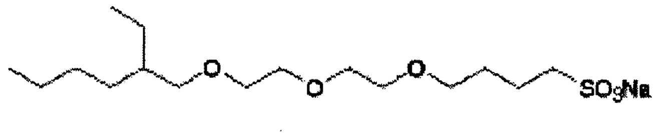

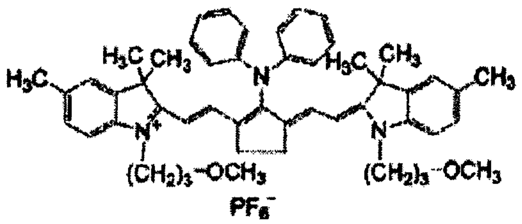

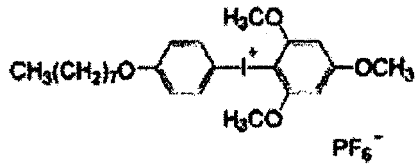

Infrared absorber (1)

Polymerization initiator (1)

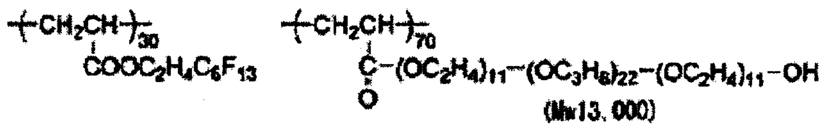

Fluorine-based surfactant (1)

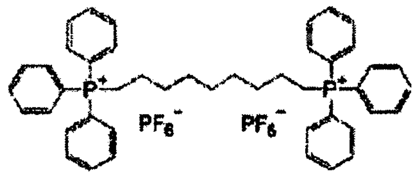

Phosphonium compound (1)

A preparation method of the above-described microgel (1) is as shown below.

(Preparation of Microgel (1))

As an oil phase component, 10 g of an adduct (TAKENATE D-110N manufactured by Mitsui Chemicals Polyurethanes Inc.) of trimethylol propane and xylene diisocyanate, 3.15 g of pentaerythritol triacrylate (SR444 manufactured by Nippon Kayaku Co., Ltd.), and 0.1 g of PIONIN A-41C (manufactured by Takemoto Oil & Fat Co., Ltd.) were dissolved in 17 g of ethyl acetate. As a water phase component, 40 g of a 4 mass% aqueous solution of polyvinyl alcohol (PVA-205 manufactured by Kuraray Co., Ltd.) was prepared. The oil phase component and the water phase component were mixed with each other and emulsified for 10 minutes at 12,000 rpm using a homogenizer. The obtained emulsion was added to 25 g of distilled water, stirred for 30 minutes at room temperature, and stirred for 3 hours at 50°C. The resultant was diluted with distilled water such that the solid content concentration of the microgel liquid obtained in this manner became 15 mass%, to prepare the above-described microgel (1). The average particle diameter of the microgel was measured through a light scattering method, and as a result, the average particle diameter was 0.2 μm.

(4) Formation of Protective Layer

A lithographic printing plate precursor I was produced such that the top of the above-described image recording layer was bar-coated with a protective layer coating liquid (1) having the following composition, and was then oven-dried for 60 seconds at 120°C to form a protective layer having a dry coating amount of 0.15 g/m$^2$.

<Coating Liquid (1) for Protective Layer>

- Inorganic layer-shaped compound dispersion liquid (1) 1.5 g
- Hydrophilic polymer (1) (solid content) [following structure, Mw: 30,000] 0.55 g
- 6 mass% Polyvinyl alcohol (CKS50 manufactured by The Nippon synthetic Chemical Industry Co., Ltd., sulfonic acid-modified, saponification degree of greater than or equal to 99 mol%, and polymerization degree of 300) aqueous solution 0.10 g
- 6 mass% polyvinyl alcohol (PVA-405 manufactured by Kuraray Co., Ltd., saponification degree of 81.5 mol%, and polymerization degree of 500) aqueous solution 0.03 g
- 1 mass% surfactant (EMALEX 710, product name: manufactured by Nihon Emulsion Co., Ltd.) aqueous solution 0.86 g
- Ion exchanged water 6.0 g

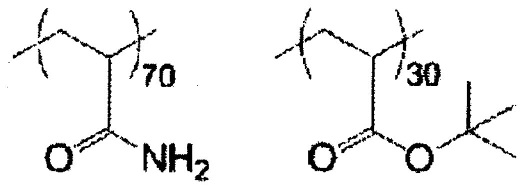

Hydrophilic polymer (1)

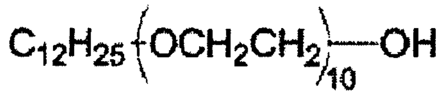

EMALEX 710

(Preparation of Inorganic Layer-Shaped Compound Dispersion Liquid (1))

6.4 g of a synthetic mica SOMASHIF ME-100 (manufactured by Co-op Chemical Co., Ltd.) was added to 193.6 g of ion exchanged water, and was dispersed using a homogenizer until the average particle diameter (laser dispersion method) became 3 μm. The aspect ratio of the obtained dispersion particles was greater than or equal to 100.

[Production of Lithographic Printing Plate Precursor II]

(Production of Support)

An aluminum sheet having a thickness of 0.19 mm was degreased by immersing the aluminum sheet in a 40 g/l sodium hydroxide aqueous solution for 8 seconds at 60°C, and was washed using desalted water for 2 seconds. Next, electrochemical roughening processing was performed on the aluminum sheet in an aqueous solution containing a 12 g/l hydrochloric acid and 38 g/l aluminum sulfate (octadecahydrate) at a temperature of 33°C and at a current density of 130 A/dm$^2$ using an alternating current for 15 seconds. After the aluminum sheet was washed for 2 seconds using desalted water, desmutting processing was performed by etching the aluminum sheet using a 155 g/l sulfuric acid aqueous solution for 4 seconds at 70°C, and the aluminum sheet was washed using desalted water for 2 seconds at 25°C. The aluminum sheet was subjected to anodic oxidation processing in a 155 g/l sulfuric acid aqueous solution for 13 seconds at a temperature of 45°C and a current density of 22 A/dm$^2$, and was washed using desalted water for 2 seconds. The aluminum sheet was further subjected to processing using a 4 g/l polyvinyl phosphonic acid aqueous solution for 10 seconds at 40°C, washed using desalted water for 2 seconds at 20°C, and then, dried. A support obtained in this manner has a surface roughness Ra of 0.21 μm and an anodic oxidation coating amount of 4 g/m$^2$.

(Production of Lithographic Printing Plate Precursor)

A water-based coating liquid for an image recording layer containing a thermoplastic fine particle polymer, an infrared absorber, and a polyacrylic acid described below was prepared, and the pH thereof was adjusted to 3.6. Thereafter, an image recording layer was formed by coating the top of above-described support with the water-based coating liquid and drying the support for 1 minute at 50°C, to produce a lithographic printing plate precursor II. The coating amount after drying each component is shown below.

Thermoplastic fine particle polymer: 0.7 g/$m^2$
Infrared absorber IR-01: 0.104 g/$m^2$
Polyacrylic acid: 0.09 g/$m^2$

The thermoplastic fine particle polymer, the infrared absorber IR-01, and the polyacrylic acid used in the above-described coating liquid for an image recording layer are as shown below.
Thermoplastic fine particle polymer: styrene/acrylonitrile copolymer (molar ratio of 50/50), Tg: 99°C, and average particle diameter: 60 nm
Infrared absorber IR-01: infrared absorber having the following structure

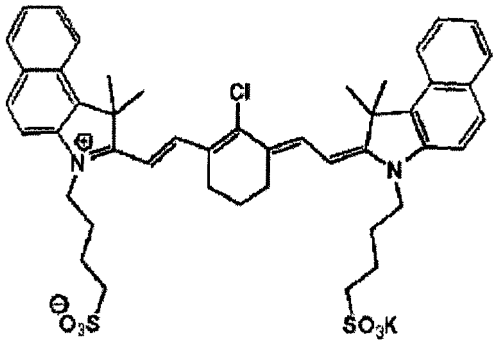

Polyacrylic acid: mass average molecular weight: 250,000

[Production of Lithographic Printing Plate Precursor III]

(1) Formation of Image Recording Layer

A lithographic printing plate precursor III was produced such that the support having an undercoat layer used for the production of the lithographic printing plate precursor I was bar-coated with an image recording layer coating liquid (2) having the following composition, and was then oven-dried for 60 seconds at 70°C to form an image recording layer having a dry coating amount of 0.6 g/$m^2$.

<Image Recording Layer Coating Liquid (2)>

- Polymer compound fine particle water dispersion liquid (1) 20.0 g
- Infrared absorber (2) [following structure] 0.2 g
- Polymerization initiator IRGACURE 250 (manufactured by Ciba Specialty Chemicals Inc.) 0.5 g
- Polymerizable compound SR-399 (manufactured by Sartomer) 1.50 g
- Mercapto-3-triazol 0.2 g
- BYK336 (manufactured by BYK Chemie GmbH) 0.4 g
- KLUCEL M (manufactured by Hercules, Inc.) 4.8 g
- ELVACITE 4026 (manufactured by INEOS Acrylics) 2.5 g
- Anionic surfactant 1 [above-described structure] 0.15 g
- n-Propanol 55.0 g
- 2-Butanone 17.0 g

Compounds described as the product names in the above-described composition are as follows.

- IRGACURE 250: (4-methylphenyl)[4-(2-methylpropyl) phenyl]iodonium=hexafluorophosphate (75 mass% propylene carbonate solution)
- SR-399: dipentaerythritol pentaacrylate
- BYK 336: modified dimethylpolysiloxane copolymer (25 mass% xylene/methoxypropyl acetate solution)
- KLUCEL M:hydroxypropyl cellulose (2 mass% aqueous solution)
- ELVACITE 4026: high branched polymethyl methacrylate (10 mass% 2-butanone solution)

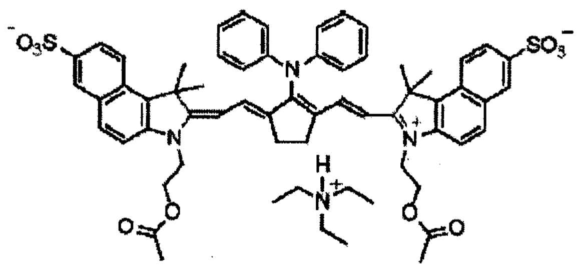

Infrared absorber dye (2)

(Preparation of Polymer Compound Fine Particle Water Dispersion Liquid (1))

A stirrer, a thermometer, a drop rod, a nitrogen introducing pipe, and a reflux cooler were provided in a 1000-ml 4-necked flask, 10 g of polyethylene glycol methyl ether methacrylate (PEGMA, an average repeating unit of ethylene glycol was 20), 200 g of distilled water, and 200 g of n-propanol were added thereto while deoxidation was performed by introducing nitrogen gas, and heating was performed until the internal temperature became 70°C. Subsequently, a mixture of 10 g of styrene (St) which was mixed in advance, 80 g of acrylonitrile (AN), and 0.8 g of 2,2'-azobisisobutyronitrile was dripped over 1 hour. After the completion of the dripping, a reaction was continued for 5 hours without change, 0.4 g of 2,2'-azobisisobutyronitrile was added thereto, and the internal temperature was increased to 80°C. Subsequently, 0.5 g of 2,2'-azobisisobutyronitrile was added thereto over 6 hours. In a stage in which the reaction was performed for 20 hours in total, polymerization was performed by 98% or more, and a polymer compound fine particle water dispersion liquid (1) in which PEGMA/St/AN = 10/10/80 in a mass ratio was obtained. The particle diameter distribution of the polymer compound fine particle had a maximum value in the particle diameter of 150 nm.

The particle distribution was obtained by photographing an electron micrograph of the polymer compound fine particle, measuring particle diameters of 5000 fine particles in the photograph in total, dividing the obtained measurement values of the particle diameters between the maximum value and 0 into 50 with a logarithmic scale, and plotting appearance frequencies of respective particle diameters. With respect to a non-spherical particle, a particle diameter value of a spherical particle having the same particle area to the particle area on the photograph was set to a particle diameter thereof.

[Cutting of Lithographic Printing Plate Precursor]

The lithographic printing plate precursor was continuously slit using a rotary blade as shown in Fig. 2 such that the shape of an end portion has predetermined amount of shear drop and width of shear drop by adjusting the gap between an upper cutting blade and a lower cutting blade, the biting amount, and the blade tip angle.

The measurement of the shape of the cut lithographic printing plate precursor was performed using a surface roughness meter (SURFCOM) manufactured by TOKYO SEMITSU CO., LTD. A model number 480A was used as the surface roughness meter and a tracer having a diameter of 2 μm was used. The shape of the lithographic printing plate precursor was measured after moving the tracer from a position about 1 mm on the inside of the end portion of the lithographic printing plate precursor toward the end portion at a speed of 3 mm/sec. As a result, the amount of shear drop was 60 μm and the width of shear drop was 100 μm.

[Image Exposure]

The lithographic printing plate precursor was exposed using LUXEL PLATESETTER T-6000 III manufactured by FUJIFILM Corporation which is equipped with an infrared semiconductor laser under the conditions of the number of revolutions of an outer drum of 1000 rpm, a laser output of 70%, and a resolution of 2400 dpi. In the exposure image, a solid image and a 50% halftone dot chart were included.

[Preparation of Processing liquid]

Compounds described in the following Table 1 were dissolved in pure water to prepare processing liquids A to I. The numbers within brackets represent concentrations (mass%) of the compounds.

The compounds described as product names in Table 1 are as follows.

- NEWCOL B13 (nonionic surfactant and polyoxyethylene aryl ether manufactured by Nippon Nyukazai Co, Ltd.)
- PELEX NBL (anionic surfactant and sodium alkyl naphthalene sulfonic acid manufactured by Kao Corporation)
- RAPISOL A-80 (anionic surfactant and di(2-ethylhexyl)sodium sulfosuccinate manufactured by NOF Corporation)

[Table 6]

Table 1

| Processing liquid | Hydrophilizing agent (mass%) |
|---|---|
| A | NEWCOL B 13 (7.5) + sodium dihydrogen phosphate (1.5) |
| B | Sodium 1-naphthalene sulfonate (7.5) + sodium dihydrogen phosphate (1.5) |
| C | PELEX NBL (7.5) + sodium hexametaphosphate (1.5) |
| D | Sodium 1-naphthalene sulfonate (7.5) + sodium polyvinyl phosphonate (1.5) |
| E | Sodium 1-naphthalene sulfonate (7.5) |
| F | Sodium dihydrogen phosphate (1.5) |
| G | Sodium polyvinyl phosphonate (1.5) |
| H | NEWCOL B13 (7.5) |
| I | Sodium 1-naphthalene sulfonate (7.5) + sodium dihydrogen phosphate (1.5) + RAPISOL A-80 (0.1) |

[Coating of End Portion of Plate Surface of Lithographic Printing Plate Precursor with Processing Liquid]

(Coating Method 1)

As a coating device, non-contact dispenser type AEROJET manufactured by Musashi Engineering, Inc. was used. A region of 0.3 cm from an end portion of the lithographic printing plate precursor was coated with the processing liquid by adjusting the transporting speed such that the coating amount (solid content) became 0.8 $g/m^2$ under the conditions of a clearance of 6 mm and a discharge pressure of 0.05 MPa. Then, drying was performed using a thermostatic device PH-201 manufactured by ESPEC CORP. for 1 minute at 120°C.

(Coating Method 2)

Cloth containing the above-described processing liquid was brought into contact with an end portion of a lithographic printing plate precursor, and a region at least 0.5 cm from the end portion of the lithographic printing plate precursor was coated with the processing liquid while making the cloth slide along the end portion such that the coating amount becomes the same as that in the coating method 1. Then, drying was performed using a thermostatic device PH-201 manufactured by ESPEC CORP. for 1 minute at 120°C.

(Coating Method 3)

Cloth containing the above-described processing liquid was brought into contact with an end portion of a lithographic printing plate precursor, and a region at least 0.5 cm from the end portion of the lithographic printing plate precursor was coated with the processing liquid while pressing the cloth from above such that the coating amount becomes the same as that in the coating method 1. Then, drying was performed using a thermostatic device PH-201 manufactured by ESPEC CORP. for 1 minute at 120°C.

(Coating Method 4)

A brush containing the above-described processing liquid was brought into contact with an end portion of a lithographic printing plate precursor, and a region at least 0.5 cm from the end portion of the lithographic printing plate precursor was coated with the processing liquid such that the coating amount becomes the same as that in the coating method 1. Then, drying was performed using a thermostatic device PH-201 manufactured by ESPEC CORP. for 1 minute

at 120°C.

[Evaluation]

(Evaluation of Edge Stains)

<Printing under Condition of Standard Water Scale>

The lithographic printing plate precursor of which the end portion was processed after image exposure as described above was mounted on an offset rotary printing press, and printing was performed in a standard water scale using SOIBI KKST-S (red) manufactured by The Inktec Inc. as printing ink for newspaper and TOYO ALKY manufactured by Toyo Ink CO., LTD. as dampening water at a speed of 100,000 sheets/hour. The 1,000th sheet of a printed matter was sampled to evaluate the degree of linear stains of edge portions according to the following criteria.

5: No stain at all
4: Intermediate level between 5 and 3
3: Slight stain in permissible level
2: Intermediate level between 3 and 1
1: Obvious stains in impermissible level

<Printing under Condition of Decrease in Amount of Water by 15% from Standard Water Scale>

Printing and Evaluation were performed similarly to the above except that the amount of dampening water was changed to 15% decrease from standard water scale.
The results are shown in Table 2.

(Evaluation of Stains in Non-Image Portion)

Regarding the 1,000th sheet which has been printed under the above-described condition of the standard water scale, the degree of stains in a unexposed portion in a region (a region in the vicinity of an edge portion) near a boundary between a portion which is coated with a processing liquid and a portion which is not coated with a processing liquid was evaluated according to the following standards.

3: Non-image portion is not stained.

2: Non-image portion is slightly stained.

1: Non-image portion is quite stained.

[Table 7]

Table 2

| | Lithographic printing plate precursor | Processing liquid | Coating method (contact · non-contact) | Edge stains | | Stains in non-image portion |
|---|---|---|---|---|---|---|
| | | | | Printing in standard water scale | Printing in decrease in 15% from standard water scale | |
| Example 1 | I | A | 1 (non-contact) | 5 | 5 | 3 |
| Example 2 | I | B | 1 (non-contact) | 5 | 5 | 3 |
| Example 3 | I | C | 1 (non-contact) | 5 | 5 | 3 |

(continued)

| | Lithographic printing plate precursor | Processing liquid | Coating method (contact · non-contact) | Edge stains | | Stains in non-image portion |
|---|---|---|---|---|---|---|
| | | | | Printing in standard water scale | Printing in decrease in 15% from standard water scale | |
| Example 4 | II | B | 1 (non-contact) | 4 | 4 | 3 |
| Example 5 | III | B | 1 (non-contact) | 4 | 4 | 3 |
| Example 6 | I | D | 1 (non-contact) | 5 | 5 | 3 |
| Example 7 | I | E | 1 (non-contact) | 5 | 4 | 3 |
| Example 8 | I | F | 1 (non-contact) | 5 | 4 | 3 |
| Example 9 | I | G | 1 (non-contact) | 5 | 4 | 3 |
| Example 10 | I | H | 1 (non-contact) | 5 | 4 | 3 |
| Example 11 | I | I | 1 (non-contact) | 5 | 5 | 3 |
| Comparative Example 1 | I | A | 2 (contact) | 4 | 3 | 1 |
| Comparative Example 2 | I | A | 3 (contact) | 4 | 2 | 2 |
| Comparative Example 3 | I | A | 4 (contact) | 4 | 2 | 1 |
| Comparative Example 4 | I | No processing | - | 1 | 1 | 3 |

As is clear from the results shown in the above-described Table 2, according to the processing method of the present invention in which coating is performed using a processing method containing a hydrophilizing agent such that coating means does not come into contact with the surface of a plate, edge stains are not generated and there is no stain in the non-image portion. Furthermore, even in a case where the amount of dampening water during printing is made small, a favorable effect of preventing edge stains is recognized. In contrast, it was found that, in Comparative Examples 1 to 3 in which coating is performed while coating means comes into contact with the surface of a plate, in a case where the amount of dampening water during printing is made small, the effect of preventing edge stains is deteriorated.

Industrial Applicability

According to the present invention, it is possible to provide a method for processing an on-press development-type lithographic printing plate precursor and a printing method which do not cause edge stains and in which there are no stains in an unexposed portion in a region in the vicinity of and edge portion. The method of the present invention will result in a lithographic printing plate having a wide water width during printing with respect to the edge stains.

The present invention has been described in detail or with reference to a specific embodiment. However, it is obvious to a person skilled in the art that it is possible to make various changes or modifications without departing from the gist and the scope of the present invention.

Explanation of References

1: lithographic printing plate precursor
1a: image recording layer surface
1b: support surface
1c: end surface
2: sag
10: cutting blade
10a: upper cutting blade
10b: upper cutting blade
11: rotary shaft
20: cutting blade
20a: lower cutting blade
20b: lower cutting blade
21: rotary shaft
30: lithographic printing plate precursor
X: amount of shear droop
Y: width of shear droop
B: boundary between image recording layer and support

## Claims

1. A method for processing an on-press development-type lithographic printing plate precursor (1) having an image recording layer on a support in which a region within 1 cm from an end portion on a plate surface of the precursor (1) is coated with a processing liquid containing a hydrophilizing agent after subjecting the precursor (1) to image exposure and before mounting it on a printing press, wherein

    - the coating is performed such that coating means does not come into contact with the plate surface, and
    - the end portion of the lithographic printing plate precursor has a shear droop shape with an amount X of shear droop of 35-150 μm and a width Y of shear droop of 50-300 μm.

2. The method of claim 1, wherein the coating means is a quantitative liquid discharge device.

3. The method of claim 1 or 2, wherein the hydrophilizing agent is at least one selected from a phosphoric acid compound, a phosphonic acid compound, an anionic surfactant and a nonionic surfactant.

4. The method of claim 3, wherein the hydrophilizing agent is at least one selected from a phosphoric acid compound and a phosphonic acid compound, and at least one selected from an anionic surfactant and a nonionic surfactant.

5. The method of any of claims 1-4, wherein the image recording layer contains an infrared absorber, a polymerization initiator, a polymerizable compound, and a binder polymer.

6. The method of any of claims 1-4, wherein the image recording layer contains an infrared absorber, a polymerization initiator, a polymerizable compound, and a particulate shape polymer compound selected from hydrophobic thermoplastic polymer fine particles, thermally reactive polymer fine particles, polymer fine particles having a polymerizable group, a microcapsule including a hydrophobic compound, and microgel (crosslinking polymer fine particles).

7. The method of any of claims 1-4, wherein the image recording layer contains an infrared absorber and a thermoplastic fine particle polymer.

8. A printing method in which the lithographic printing plate precursor processed through the method of any of claims 1-7 is printed after being subjected to on-press development by being mounted on a cylinder of the printing press and supplying ink and dampening water to the lithographic printing plate precursor.

## Patentansprüche

1. Verfahren zur Verarbeitung eines Lithografiedruckplattenvorläufers mit Entwicklung auf der Presse (1) mit einer Bildaufzeichnungsschicht auf einem Träger, in dem ein Bereich innerhalb von 1 cm von einem Endabschnitt auf einer Plattenoberfläche des Vorläufers (1) mit einer Verarbeitungsflüssigkeit beschichtet wird, die ein Hydrophilisierungsmittel enthält, nachdem der Vorläufer (1) einer Bildbelichtung unterworfen wurde und bevor er auf einer Druckpresse montiert wurde, worin

   - die Beschichtung so durchgeführt wird, dass das Beschichtungsinstrument nicht mit der Plattenoberfläche in Kontakt kommt und
   - der Endbereich des Lithografiefruckplattenvorläufers eine Ausprägung an Scher-Ungleichmäßigkeit mit einer Menge X an Scher-Ungleichmäßigkeit von 35-150 $\mu$mund einer Breite Y an Scher-Ungleichmäßigkeit von 50-300 $\mu$m aufweist.

2. Verfahren gemäß Anspruch 1, worin das Beschichtungsinstrument eine Vorrichtung zur quantitativen Flüssigkeitsentladung ist.

3. Verfahren gemäß Anspruch 1 oder 2, worin das Hydrophilisierungsmittel mindestens eines ist, ausgewählt aus einer Phosphorsäure-Verbindung, einer Phosphonsäure-Verbindung, einem anionischen Tensid und einem nichtionischen Tensid.

4. Verfahren gemäß Anspruch 3, worin das Hydrophilisierungsmittel mindestens eines, ausgewählt aus einer Phosphorsäure-Verbindung und einer Phosphonsäure-Verbindung, und mindestens eines, ausgewählt aus einem anionischen Tensid und einem nichtionischen Tensid, ist.

5. Verfahren gemäß mindestens einem der Ansprüche 1-4, worin die Bildaufzeichnungsschicht einen Infrarotabsorber, einen Polymerisationsinitiator, eine polymerisierbare Verbindung und ein Bindemittelpolymer enthält.

6. Verfahren gemäß mindestens einem der Ansprüche 1-4, worin die Bildaufzeichnungsschicht einen Infrarotabsorber, einen Polymerisationsinitiator, eine polymerisierbare Verbindung und eine partikelförmige Polymerverbindung enthält, ausgewählt aus hydrophoben thermoplastischen Polymerfeinpartikeln, thermisch reaktiven Polymerfeinpartikeln, Polymerfeinpartikeln mit einer polymerisierbaren Gruppe, einer Mikrokapsel, die eine hydrophobe Verbindung umfasst, und Mikrogel (vernetzende Polymerfeinpartikel).

7. Verfahren gemäß mindestens einem der Ansprüche 1-4, worin die Bildaufzeichnungsschicht einen Infrarotabsorber und ein thermoplastisches Feinpartikelpolymer enthält.

8. Druckverfahren, bei dem der Lithografiedruckplattenvorläufer, der durch das Verfahren nach mindestens einem der Ansprüche 1 bis 7 hergestellt wurde, nach der Entwicklung auf der Presse gedruckt wird, indem er auf einem Zylinder der Druckpresse montiert wird und dem Lithografiedruckplattenvorläufer Tinte und Befeuchtungswasser zugeführt wird.

## Revendications

1. Procédé de traitement d’un précurseur de plaque d’impression lithographique de type développement sur presse (1) ayant une couche d’enregistrement d’image sur un support dans lequel une région située à 1 cm d’une partie d’extrémité sur une surface de plaque du précurseur (1) est revêtue d’un liquide de traitement contenant un agent hydrophilisant après avoir soumis le précurseur (1) à une exposition d’image et avant de le monter sur une presse à impression, dans lequel

   - le revêtement est réalisé de sorte que les moyens de revêtement n’entrent pas en contact avec la surface de la plaque, et
   - la partie d’extrémité du précurseur de plaque d’impression lithographique a une forme avec une chute de découpe avec une quantité X de chute de découpe de 35-150 $\mu$m et une largeur Y de chute de découpe de 50-300 $\mu$m.

2. Procédé selon la revendication 1, dans lequel les moyens de revêtement sont un dispositif quantitatif de décharge

de liquide.

3. Procédé selon la revendication 1 ou 2, dans lequel l'agent d'hydrophilisation est au moins un composé choisi parmi un composé d'acide phosphorique, un composé d'acide phosphonique, un tensioactif anionique et un tensioactif non ionique.

4. Procédé selon la revendication 3, dans lequel l'agent d'hydrophilisation est au moins l'un choisi parmi un composé d'acide phosphorique et un composé d'acide phosphonique, et au moins l'un choisi parmi un tensioactif anionique et un tensioactif non ionique.

5. Procédé selon l'une quelconque des revendications 1 à 4, dans lequel la couche d'enregistrement d'image contient un absorbeur infrarouge, un initiateur de polymérisation, un composé polymérisable et un polymère liant.

6. Procédé selon l'une quelconque des revendications 1 à 4, dans lequel la couche d'enregistrement d'image contient un absorbeur d'infrarouges, un initiateur de polymérisation, un composé polymérisable et un composé polymère sous forme de particules choisi parmi des particules fines de polymère thermoplastique hydrophobe, des particules fines de polymère thermiquement réactif, des particules fines de polymère ayant un groupe polymérisable, une microcapsule comprenant un composé hydrophobe et un micro-gel (particules fines de polymère de réticulation).

7. Procédé selon l'une quelconque des revendications 1 à 4, dans lequel la couche d'enregistrement d'image contient un absorbeur d'infrarouges et un polymère thermoplastique à particules fines.

8. Procédé d'impression dans lequel le précurseur de plaque d'impression lithographique traité par le procédé selon l'une quelconque des revendications 1 à 7 est imprimé après avoir été soumis à un développement sur presse en étant monté sur un cylindre de la presse d'impression et en fournissant de l'encre et de l'eau de mouillage au précurseur de plaque d'impression lithographique.

FIG. 1

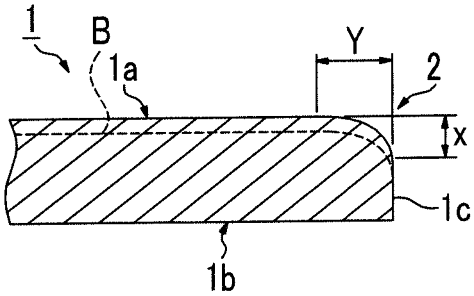


FIG. 2

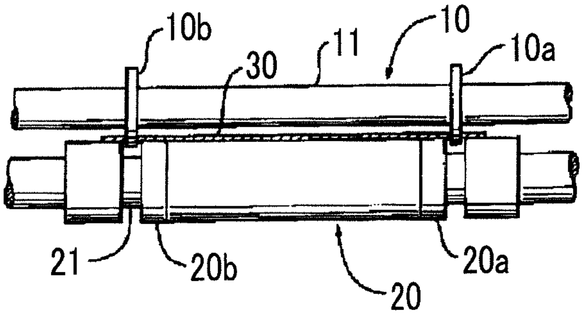

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2011177983 A
- JP 2001133969 A
- JP 2002023360 A
- JP 2002040638 A
- JP 2002278057 A
- JP 2008195018 A
- JP 2007090850 A
- JP 5005005 A
- JP H55005 A
- JP 2001222101 A
- JP 8108621 A
- JP H8108621 A
- JP 61166544 A
- JP S61166544 A
- JP 5158230 A
- JP H5158230 A
- US 4069055 A
- JP 4365049 A
- JP H4365049 A
- US 4069056 A
- EP 104143 B
- US 20080311520 A
- JP 2150848 A
- JP H2150848 A
- EP 370693 B
- EP 233567 B
- EP 297443 B
- EP 297442 B
- US 4933377 A
- US 4760013 A
- US 4734444 A
- US 2833827 A
- DE 2904626 B
- DE 3604580 B
- DE 3604581 B
- JP 2006508380 A
- JP 2002287344 A
- JP 2008256850 A
- JP 2001342222 A
- JP 9179296 A
- JP H9179296 A
- JP 9179297 A
- JP H9179297 A
- JP 9179298 A
- JP H9179298 A
- JP 2004294935 A
- JP 2006243493 A
- JP 2002275129 A
- JP 2003064130 A
- JP 2003280187 A
- JP 10333321 A
- JP H10333321 A
- JP 48041708 B
- JP 51037193 A
- JP S5137193 A
- JP 2032293 B
- JP H232293 B
- JP 2016765 B
- JP H216765 B
- JP 2003344997 A
- JP 2006065210 A
- JP 58049860 B
- JP S5849860 B
- JP 56017654 B
- JP S5617654 B
- JP 62039417 B
- JP S6239417 B
- JP 62039418 B
- JP S6239418 B
- JP 2000250211 A
- JP 2007094138 A
- US 7153632 B
- JP 8505958 A
- JP H8505958 A
- JP 2007293221 A
- JP 2007293223 A
- JP 7021633 B
- JP H721633 B
- JP 2012148555 A
- JP 2007276454 A
- JP 2009154525 A
- JP 2006297907 A
- JP 2007050660 A
- JP 2008284858 A
- JP 2009090645 A
- JP 2009208458 A
- JP 2008284817 A
- JP 2006091479 A
- JP 9123387 A
- JP H9123387 A
- JP 9131850 A
- JP H9131850 A
- JP 9171249 A
- JP H9171249 A
- JP 9171250 A
- JP H9171250 A

- EP 931647 B
- JP 2001277740 A
- JP 2001277742 A
- WO 9634316 A
- JP 62170950 A
- JP S62170950 A
- JP 10282679 A
- JP H10282679 A
- JP 2304441 A
- JP H2304441 A
- JP 2005125749 A
- JP 2006188038 A
- JP 2001253181 A
- JP 2001322365 A
- US 2714066 A
- US 3181461 A
- US 3280734 A
- US 3902734 A
- US 3276868 A
- US 4153461 A
- US 4689272 A
- JP 5045885 A
- JP H545885 A
- JP 6035174 A
- JP H635174 A
- US 3458311 A
- JP 55049729 B
- JP S5549729 B
- JP 2005250216 A
- JP 2006259137 A
- JP 2005119273 A
- JP 8058257 A
- JP H858257 A
- JP 9211843 A
- JP H9211843 A
- JP 10100556 A
- JP H10100556 A
- JP 11052579 A
- JP H1152579 A


**Non-patent literature cited in the description**


- Latest Pigment Handbook. Society of Colour Material, 1977
- Latest Pigment Application Technology. CMC Publishing Co., Ltd, 1986
- Printing Ink Technology. CMC Publishing Co., Ltd, 1984
- **S. I. SCHLESINGER.** *Photogr. Sci. Eng.,* 1974, vol. 18, 387
- **T. S. BAL et al.** *Polymer,* 1980, vol. 21, 423
- **J. V. CRIVELLO et al.** *Macromolecules,* 1977, vol. 10 (6), 1307
- **J. V. CRIVELLO et al.** *J. Polymer Sci., Polymer Chem. Ed.,* 1979, vol. 17, 1047
- **C. S. WEN et al.** *Teh, Proc. Conf. Rad. Curing ASIA,* September 1988, 478
- Dye Handbook. The Society of Synthetic Organic Chemistry, 1970, S45
- Near Infrared Absorption Coloring Matters. Chemical Industry, May 1986, 45-51
- Development and Market Trends of Functional Dyes in the. CMC Publishing Co., Ltd, 1990
- Latest Pigment Handbook. 1977